# EUROPEAN PATENT APPLICATION

(11) **EP 3 667 268 A1**
(43) Date of publication of application: **17.06.2020**
(21) Application number: 18844342.8
(22) Date of filing: 24.07.2018
(51) Int. Cl.: G01J 1/02

(54) **LIGHT DETECTOR**

(30) Priority: 10.08.2017 JP 2017155979
(71) Applicant: Hamamatsu Photonics K.K., Hamamatsu-shi, Shizuoka 435-8558 (JP)
(72) Inventor: YAMAZAKI Masahiro, Hamamatsu-shi Shizuoka 435-8558 (JP); SHIBAYAMA Katsumi, Hamamatsu-shi Shizuoka 435-8558 (JP); KITAURA Ryusuke, Hamamatsu-shi Shizuoka 435-8558 (JP)
(74) Representative: Hoffmann Eitle
(86) International application number: PCT/JP2018/027741
(87) International publication number: WO 2019/031235

(57) **Abstract**

A light detector includes a light detecting element and a reference element. The reference element includes a second substrate and a second membrane disposed on a second surface so as to form a void space between the second membrane and the second surface of the second substrate. The second membrane includes a pair of second wiring layers facing each other with a second gap extending along a second line interposed therebetween and a second resistance layer electrically connected to each of the pair of second wiring layers and having an electrical resistance depending on a temperature. An outer shape of the second membrane when viewed from a direction perpendicular to the second surface is a polygonal shape. The second line extends between diagonals facing each other with a geometric center position of the second membrane interposed therebetween when viewed from a direction perpendicular to the second surface.

## Description

### Technical Field

The present disclosure relates to a light detector.

### Background Art

As a light detector, there is known one including a light detecting element detecting light on the basis of a change in temperature due to the receiving of light and a reference element compensating a change in temperature due to a factor other than the receiving of light in the light detecting element. The reference element includes a substrate and a membrane disposed on a surface of the substrate so as to form a void space between the membrane and the surface of the substrate and in the membrane, a resistance layer having an electrical resistance depending on a temperature is electrically connected to each of a pair of wiring layers (for example, see Patent Literature 1).

### Citation List

### Patent Literature

Patent Literature 1: Japanese Unexamined Patent Publication No. 2015-45641

### Summary of Invention

### Technical Problem

In the above-described light detector, it is important how to secure compensation accuracy by the reference element in order to secure detection accuracy as the light detector. Particularly, when one reference element is used for the compensation of the plurality of light detecting elements, the reference element is more likely to deteriorate than the light detecting element. As a result, a device for securing the compensation accuracy by the reference element is necessary.

Here, an object of the present disclosure is to provide a light detector capable of securing compensation accuracy by a reference element.

### Solution to Problem

A light detector of an aspect of the present disclosure includes a light detecting element which detects light on the basis of a change in temperature due to receiving of light and a reference element which compensates a change in temperature due to a factor other than the receiving of light in the light detecting element, in which the light detecting element includes a first substrate and a first membrane which is disposed on a first surface of the first substrate so as to form a void space between the first membrane and the first surface, in which the first membrane includes a pair of first wiring layers which faces each other with a first gap extending along a first line interposed therebetween and a first resistance layer which is electrically connected to each of the pair of first wiring layers and has an electrical resistance depending on a temperature, in which the reference element includes a second substrate and a second membrane which is disposed on a second surface of the second substrate so as to form a void space between the second membrane and the second surface, in which the second membrane includes a pair of second wiring layers which faces each other with a second gap extending along a second line interposed therebetween and a second resistance layer which is electrically connected to each of the pair of second wiring layers and has an electrical resistance depending on a temperature, in which an outer shape of the second membrane when viewed from a direction perpendicular to the second surface is a polygonal shape, and in which the second line extends between diagonals facing each other with a geometric center position of the second membrane interposed therebetween when viewed from a direction perpendicular to the second surface.

In the light detector, the pair of second wiring layers face each other through the second gap extending between diagonals facing each other with the geometric center position of the second membrane interposed therebetween in the reference element. Accordingly, the deformation (curvature, bending, or the like) of the second membrane is suppressed. Thus, according to the light detector, it is possible to secure compensation accuracy by the reference element.

In the light detector of an aspect of the present disclosure, the second line may extend in a meandering manner when viewed from a direction perpendicular to the second surface. According to this configuration, since the deformation of the second membrane is more reliably suppressed, it is possible to more reliably secure compensation accuracy by the reference element.

In the light detector of an aspect of the present disclosure, the first membrane may include a light receiving portion which has an electrical connection area between the first resistance layer and each of the pair of first wiring layers, a pair of first connection portions, and a pair of first beam portions each of which is disposed between the light receiving portion and each of the pair of first connection portions, the light detecting element may further include a pair of first electrode posts each of which is disposed between the first substrate and each of the pair of first connection portions so as to support the first membrane and to be electrically connected to each of the pair of first wiring layers, the second membrane may include a main body portion which has an electrical connection area between the second resistance layer and each of the pair of second wiring layers, a pair of second connection portions, and a pair of second beam portions each of which is disposed between the main body portion and each of the pair of second connection portions, the outer shape of the second membrane when viewed from a direction perpendicular to the second surface may be formed in the polygonal shape by the main body portion, the pair of second connection portions, and the pair of second beam portions, the reference element may further include a pair of second electrode posts each of which is disposed between the second substrate and each of the pair of second connection portions so as to support the second membrane and to be electrically connected to each of the pair of second wiring layers, and a length of each of the pair of second beam portions may be shorter than a length of each of the pair of first beam portions. According to this configuration, since the deformation of the second membrane of the reference element is suppressed as compared with the first membrane of the light detecting element, it is possible to more reliably secure compensation accuracy by the reference element.

In the light detector of an aspect of the present disclosure, the first membrane may include a light receiving portion which has an electrical connection area between the first resistance layer and each of the pair of first wiring layers, a pair of first connection portions, and a pair of first beam portions each of which is disposed between the light receiving portion and each of the pair of first connection portions, the light detecting element may further include a pair of first electrode posts each of which is disposed between the first substrate and each of the pair of first connection portions so as to support the first membrane and to be electrically connected to each of the pair of first wiring layers, the second membrane may include a main body portion which has an electrical connection area between the second resistance layer and each of the pair of second wiring layers, the outer shape of the second membrane when viewed from a direction perpendicular to the second surface may be formed in the polygonal shape by the main body portion, and the reference element may further include a pair of second electrode posts each of which is disposed between the second substrate and each of a pair of corner portions of the main body portion so as to support the second membrane and to be electrically connected to each of the pair of second wiring layers. According to this configuration, since the deformation of the second membrane of the reference element is suppressed as compared with the first membrane of the light detecting element, it is possible to more reliably secure compensation accuracy by the reference element.

In the light detector of an aspect of the present disclosure, the reference element may further include a light reflection layer which is formed on a surface at the side opposite to the second substrate in the second membrane. According to this configuration, since it is possible to prevent light from being incident to the second membrane, it is possible to easily and reliably exhibit a function for compensating a change in temperature due to a factor other than the receiving of light in the light detecting element by the reference element.

In the light detector of an aspect of the present disclosure, one of the pair of second wiring layer may spread toward the side opposite to the other of the pair of second wiring layers with respect to the second gap when viewed from a direction perpendicular to the second surface and the other of the pair of second wiring layers may spread toward the side opposite to the one of the pair of second wiring layers with respect to the second gap when viewed from a direction perpendicular to the second surface. According to this configuration, since the deformation of the second membrane is more reliably suppressed, it is possible to more reliably secure compensation accuracy by the reference element.

In the light detector of an aspect of the present disclosure, the reference element may further include a pair of third electrode posts which is disposed between the second substrate and the second membrane so as to support the second membrane and to be electrically connected to each of the pair of second wiring layers, the pair of second electrode posts may be located at the diagonals of the second membrane when viewed from a direction perpendicular to the second surface, and the pair of third electrode posts may be located at diagonals different from the diagonals of the second membrane when viewed from a direction perpendicular to the second surface. According to this configuration, since the deformation of the second membrane is more reliably suppressed, it is possible to more reliably secure compensation accuracy by the reference element.

In the light detector of an aspect of the present disclosure, an outer shape of the first membrane when viewed from a direction perpendicular to the first surface may be a polygonal shape and the first line may extend between diagonals facing each other with a geometric center position of the first membrane interposed therebetween when viewed from a direction perpendicular to the first surface. According to this configuration, since the deformation of the first membrane is suppressed, a function for detecting light on the basis of a change in temperature due to the receiving of light can be exhibited by the light detecting element.

A light detector of another aspect of the present disclosure includes a light detecting element which detects light on the basis of a change in temperature due to receiving of light and a reference element which compensates a change in temperature due to a factor other than the receiving of light in the light detecting element, in which the light detecting element includes a first substrate and a first membrane which is disposed on a first surface of the first substrate so as to form a void space between the first membrane and the first surface, in which the first membrane includes a pair of first wiring layers which faces each other with a first gap extending along a first line interposed therebetween and a first resistance layer which is electrically connected to each of the pair of first wiring layers and has an electrical resistance depending on a temperature, in which the first membrane includes a light receiving portion which has an electrical connection area between the first resistance layer and each of the pair of first wiring layers, in which the reference element includes a second substrate and a second membrane which is disposed on a second surface of the second substrate so as to form a void space between the second membrane and the second surface, in which the second membrane includes a pair of second wiring layers which faces each other with a second gap extending along a second line interposed therebetween and a second resistance layer which is electrically connected to each of the pair of second wiring layers and has an electrical resistance depending on a temperature, in which the second membrane includes a main body portion which has an electrical connection area between the second resistance layer and each of the pair of second wiring layers, in which an outer shape of the main body portion when viewed from a direction perpendicular to the second surface is a polygonal shape, and in which the second line extends between diagonals facing each other with a geometric center position of the main body portion interposed therebetween when viewed from a direction perpendicular to the second surface.

In the light detector, the pair of second wiring layers face each other through the second gap extending between diagonals facing each other with the geometric center position of the main body portion interposed therebetween in the reference element. Accordingly, the deformation (curvature, bending, or the like) of the main body portion is suppressed. Thus, according to the light detector, it is possible to secure compensation accuracy by the reference element.

### Advantageous Effects of Invention

According to the present disclosure, it is possible to provide a light detector capable of securing compensation accuracy by a reference element.

### Brief Description of Drawings

FIG. 1 is a plan view of a light detector of an embodiment.
FIG. 2 is a plan view of a pixel unit and a reference unit of the light detector of FIG. 1.
FIG. 3 is a perspective view of a light detecting element of the pixel unit of FIG. 2.
FIG. 4 is a plan view of the light detecting element of FIG. 3.
FIG. 5 is a cross-sectional view of the light detecting element of FIG. 3.
FIG. 6 is a diagram illustrating a principle of an optical resonance structure.
FIG. 7 is a perspective view of a reference element of the reference unit of FIG 2.
FIG. 8 is a plan view of the reference element of FIG. 7.
FIG. 9 is a cross-sectional view of the reference element of FIG. 7.
FIG. 10 is a diagram illustrating a method of manufacturing the light detecting element of FIG. 5.
FIG. 11 is a diagram illustrating a method of manufacturing the light detecting element of FIG. 5.
FIG. 12 is a diagram illustrating a method of manufacturing the light detecting element of FIG. 5.
FIG. 13 is a diagram illustrating a method of manufacturing the light detecting element of FIG. 5.
FIG. 14 is a diagram illustrating a method of manufacturing the light detecting element of FIG. 5.
FIG. 15 is a diagram illustrating a method of manufacturing the light detecting element of FIG. 5.
FIG. 16 is a diagram illustrating a method of manufacturing the light detecting element of FIG. 5.
FIG. 17 is a diagram illustrating a method of manufacturing the light detecting element of FIG. 5.
FIG. 18 is a diagram illustrating a method of manufacturing the light detecting element of FIG. 5.
FIG. 19 is a diagram illustrating a method of manufacturing the light detecting element of FIG. 5.
FIG. 20 is a plan view of a reference element of a modified example.
FIG. 21 is a plan view of a reference element of a modified example.
FIG. 22 is a plan view of a reference element of a modified example.
FIG. 23 is a plan view of a reference element of a modified example.
FIG. 24 is a plan view of a reference element of a modified example.
FIG. 25 is a plan view of a reference element of a modified example.
FIG. 26 is a plan view of a reference element of a modified example.
FIG. 27 is a plan view of a reference element of a modified example.
FIG. 28 is a plan view of a reference element of a modified example.
FIG. 29 is a plan view of a reference element of a modified example.

### Description of Embodiments

Hereinafter, a preferred embodiment of the present disclosure will be described in detail with reference to the drawings. Additionally, the same reference numerals will be given to the same or equivalent parts in the drawings and a redundant description thereof will be omitted.

### [Configuration of Light Detector]

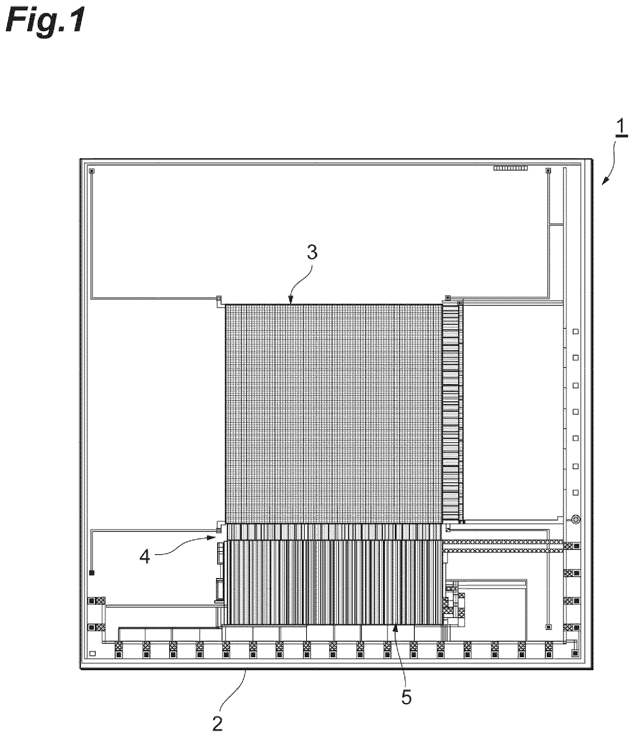

A light detector 1 illustrated in FIG. 1 detects light by using a function as a bolometer. The light is, for example, infrared light including terahertz waves. When the light is infrared light, the light detector 1 is used for an infrared imager, a thermography, or the like. The light detector 1 has excellent characteristics particularly for detecting light in a wavelength band of 1 µm to several tens of µm. As illustrated in FIG. 1, the light detector 1 includes a substrate 2, a pixel unit 3, a reference unit 4, and a signal processing circuit unit 5. The substrate 2 is, for example, a Si substrate. The thickness of the substrate 2 is, for example, about several hundreds of µm. The pixel unit 3, the reference unit 4, and the signal processing circuit unit 5 are formed on the substrate 2. Each of the pixel unit 3 and the reference unit 4 is electrically connected to the signal processing circuit unit 5. Additionally, the signal processing circuit unit 5 may be formed within the substrate 2.

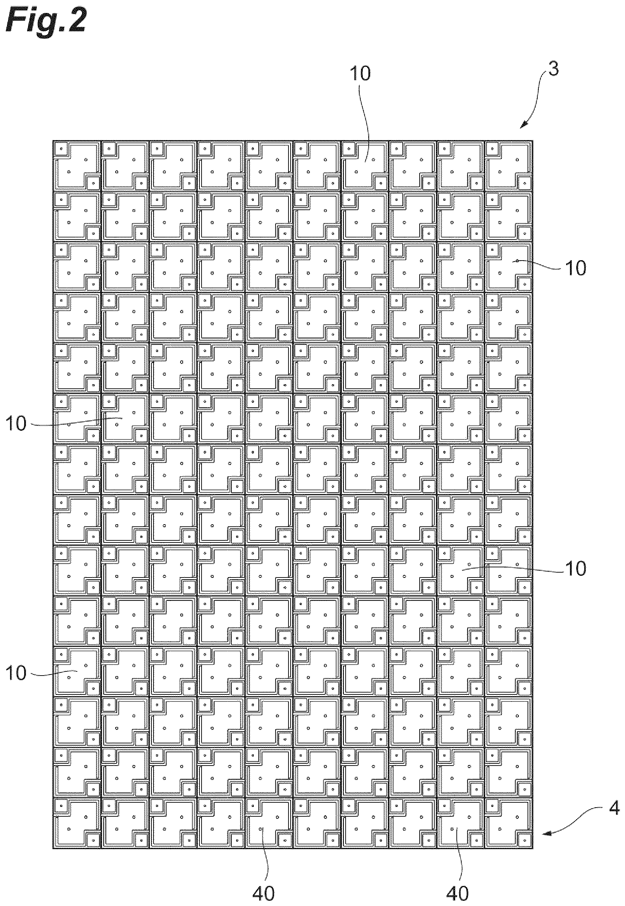

As illustrated in FIG. 2, the pixel unit 3 includes a plurality of light detecting elements 10. The plurality of light detecting elements 10 are arranged in a two-dimensional matrix shape. Each light detecting element 10 is an element that detects light on the basis of a change in temperature due to the receiving of light. The reference unit 4 includes a plurality of reference elements 40. The plurality of reference elements 40 are arranged in one dimension. Each reference element 40 is an element that compensates a change in temperature due to a factor other than the receiving of light in the light detecting element 10. In the light detector 1, one reference element 40 is used for the compensation of the plurality of light detecting elements 10 (for example, the plurality of light detecting elements 10 arranged in the same row as that of the one reference element 40).

### [Configuration of Light Detecting Element]

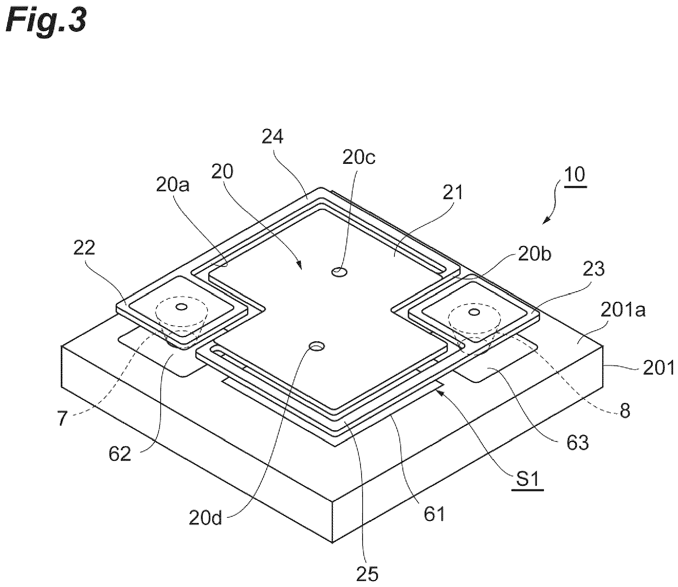

As illustrated in FIG. 3, the light detecting element 10 includes a first substrate 201 which is a part of the substrate 2, a light reflection layer 61, a pair of first electrode pads 62 and 63, a first membrane 20, and a pair of first electrode posts 7 and 8.

The light reflection layer 61 is formed on a first surface 201a of the first substrate 201. The light reflection layer 61 faces a light absorption layer 36 to be described later in the thickness direction of the first substrate 201 (that is, a direction perpendicular to the first surface 201a of the first substrate 201) and constitutes an optical resonance structure along with the light absorption layer 36. The thickness of the light reflection layer 61 is, for example, about several hundreds of nm. The material of the light reflection layer 61 is, for example, a metal material such as Al having high reflectivity with respect to light (for example, infrared light).

The pair of first electrode pads 62 and 63 are formed on the first surface 201a of the first substrate 201. The light reflection layer 61 and the first electrode pads 62 and 63 form, for example, a rectangular outer shape when viewed from the thickness direction of the first substrate 201. The first electrode pads 62 and 63 are located diagonally in the outer shape. Each of the first electrode pads 62 and 63 has, for example, a rectangular shape when viewed from the thickness direction of the first substrate 201. Each of the first electrode pads 62 and 63 is electrically connected to the signal processing circuit unit 5 through a wiring (not illustrated) formed in the first substrate 201. The thickness of each of the first electrode pads 62 and 63 is, for example, about several hundreds of nm. The material of each of the first electrode pads 62 and 63 is, for example, a conductive metal material such as Al.

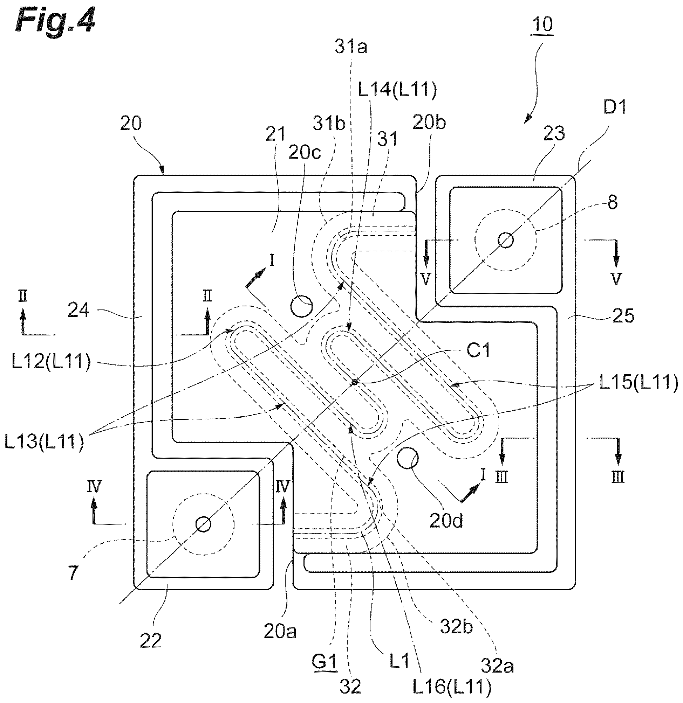

The first membrane 20 is disposed on the first surface 201a of the first substrate 201 so as to form a void space S1 between the membrane and the first surface 201a of the first substrate 201. The first membrane 20 is disposed in substantially parallel to the first surface 201a of the first substrate 201. A distance between the first membrane 20 and the first surface 201a of the first substrate 201 is, for example, about several µm. As illustrated in FIGS. 3 and 4, the first membrane 20 includes a light receiving portion 21, a pair of first connection portions 22 and 23, and a pair of first beam portions 24 and 25. The light receiving portion 21, the pair of first connection portions 22 and 23, and the pair of first beam portions 24 and 25 are integrally formed and form, for example, a rectangular outer shape when viewed from the thickness direction of the first substrate 201. The first connection portions 22 and 23 are located diagonally in the outer shape. Each of the first connection portions 22 and 23 has, for example, a rectangular shape when viewed from the thickness direction of the first substrate 201. In this way, in the light detector 1, the outer shape of the first membrane 20 when viewed from the thickness direction of the first substrate 201 is formed as a rectangular shape by the light receiving portion 21, the pair of first connection portions 22 and 23, and the pair of first beam portions 24 and 25. Additionally, the outer shape of the first membrane 20 when viewed from the thickness direction of the first substrate 201 is an entire outer shape of the first membrane 20 including the light receiving portion 21, the pair of first connection portions 22 and 23, the pair of first beam portions 24 and 25, and first slits 20a and 20b to be described later.

The light receiving portion 21 faces the light reflection layer 61 in the thickness direction of the first substrate 201. The first connection portion 22 faces the first electrode pad 62 in the thickness direction of the first substrate 201. The first connection portion 23 faces the first electrode pad 63 in the thickness direction of the first substrate 201.

The first beam portion 24 is disposed between the light receiving portion 21 and the first connection portion 22. The first beam portion 24 extends along the outer edge of the light receiving portion 21 at one side of the light receiving portion 21. One end of the first beam portion 24 is connected to the first connection portion 22 and the other end of the first beam portion 24 is connected to the light receiving portion 21 at a position in the vicinity of the first connection portion 23. First slits 20a are continuously formed between the light receiving portion 21 and the first connection portion 22 and between the light receiving portion 21 and the first beam portion 24. The first beam portion 25 is disposed between the light receiving portion 21 and the first connection portion 23. The first beam portion 25 extends along the outer edge of the light receiving portion 21 at the other side of the light receiving portion 21. One end of the first beam portion 25 is connected to the first connection portion 23 and the other end of the first beam portion 25 is connected to the light receiving portion 21 at a position in the vicinity of the first connection portion 22. The first slits 20b are continuously formed between the light receiving portion 21 and the first connection portion 23 and between the light receiving portion 21 and the first beam portion 25. The width of each of the first beam portions 24 and 25 is, for example, about several µm. The length of each of the first beam portions 24 and 25 is, for example, about several tens to several hundreds of µm. The width of each of the first slits 20a and 20b is, for example, about several µm.

The first electrode post 7 is disposed between the first substrate 201 and the first connection portion 22. Specifically, the first electrode post 7 is disposed between the first electrode pad 62 and the first connection portion 22. The first electrode post 7 has a tubular shape spreading from the first electrode pad 62 toward the side opposite to the first substrate 201. An outer surface 7a of the first electrode post 7 is provided with a groove 7b extending in an annular shape along the outer edge thereof. The groove 7b is defined by the first electrode post 7 and the first electrode pad 62. The first electrode post 7 supports the first membrane 20 and is electrically connected to a first wiring layer 31 (to be described later in detail) of the first membrane 20 and the first electrode pad 62. The first electrode post 8 is disposed between the first substrate 201 and the first connection portion 23. Specifically, the first electrode post 8 is disposed between the first electrode pad 63 and the first connection portion 23. The first electrode post 8 has a tubular shape spreading from the first electrode pad 63 toward the side opposite to the first substrate 201. An outer surface 8a of the first electrode post 8 is provided with a groove 8b extending in an annular shape along the outer edge thereof. The groove 8b is defined by the first electrode post 8 and the first electrode pad 63. The first electrode post 8 supports the first membrane 20 and is electrically connected to a first wiring layer 32 (to be described later in detail) of the first membrane 20 and the first electrode pad 63. The height of each of the first electrode posts 7 and 8 is, for example, about several µm. The material of each of the first electrode posts 7 and 8 is, for example, a metal material such as Ti.

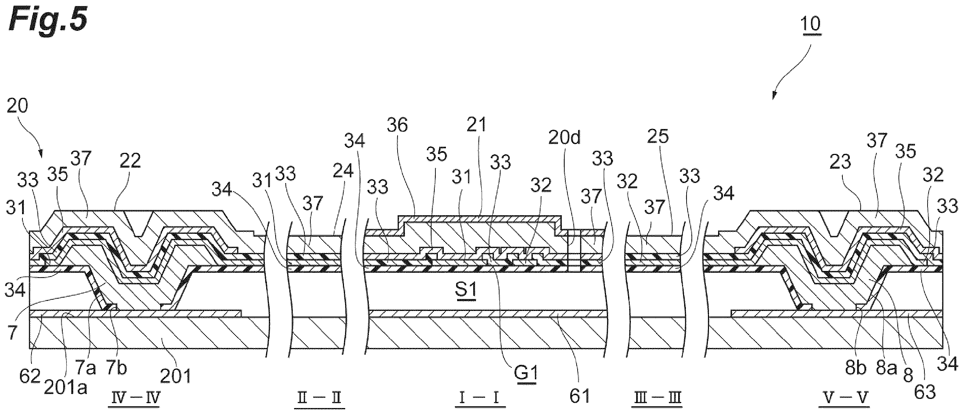

FIG. 5 is a cross-sectional view of the light detecting element 10. I-I, II-II, III-III, IV-IV, and V-V of FIG. 5 are respectively cross-sectional views taken along lines I-I, II-II, III-III, IV-IV, and V-V of FIG. 4. As illustrated in FIG. 5, the first membrane 20 includes a pair of first wiring layers 31 and 32, insulation layers 33 and 34, a first resistance layer 35, a light absorption layer 36, and a separation layer 37.

As illustrated in FIGS. 4 and 5, the first wiring layers 31 and 32 face each other with a first gap G1 interposed therebetween in the light receiving portion 21 when viewed from the thickness direction of the first substrate 201. The first gap G1 extends along a first line L1. The first line L1 extends between diagonals facing each other with a geometric center position C1 of the first membrane 20 interposed therebetween when viewed from the thickness direction of the first substrate 201. Specifically, the first line L1 extends in a meandering manner along a first diagonal line D1 passing through the geometric center position C1 in the first membrane 20 and connecting each of the first connection portions 22 and 23 when viewed from the thickness direction of the first substrate 201. The first line L1 includes a meandering portion L11. The meandering portion L11 includes a plurality of curved portions L12. The meandering portion L11 is formed in the light receiving portion 21 so as to extend to one side of the light receiving portion 21, turn back by, for example, 180° at a curved portion L12, extend to the other side of the light receiving portion 2 1, turn back by, for example, 180° at a curved portion L12, and extend to one side of the light receiving portion 21 again in a repeated manner.

In the light detecting element 10, one side means one side (for example, the existence side of the first beam portion 24) with respect to the first diagonal line D1 when viewed from the thickness direction of the first substrate 201 and the other side means the side (for example, the existence side of the first beam portion 25) opposite to one side with respect to the first diagonal line D1 when viewed from the thickness direction of the first substrate 201.

The meandering portion L11 includes a first section L13, a second section L14, a third section L15, and a fourth section L16 when viewed from the thickness direction of the first substrate 201. The first section L13 swings to one side by a first swing amount. The second section L14 swings to one side by a second swing amount. The second section L14 is sandwiched between two first sections L13 in a direction along the first diagonal line D1 when viewed from the thickness direction of the first substrate 201. The third section L15 swings to the other side by a first swing amount. The fourth section L16 swings to the other side by a second swing amount. The fourth section L16 is sandwiched between two third sections L15 in a direction along the first diagonal line D1 when viewed from the thickness direction of the first substrate 201. The first swing amount is larger than a predetermined amount. The second swing amount is smaller than a predetermined amount. The first swing amount is, for example, about dozens of µm. The second swing amount is, for example, about several µm.

Specifically, in the light receiving portion 21, the first section L13 extends to one side of the light receiving portion 21 by the first swing amount, turns back by, for example, 180° at the curved portion L12, and extends to the other side of the light receiving portion 21 by the first swing amount. Then, the fourth section L16 extends to the other side of the light receiving portion 21 by the second swing amount, turns back by, for example, 180° at the curved portion L12, and extends to one side of the light receiving portion 21 by the second swing amount. Then, the second section L14 extends to one side of the light receiving portion 21 by the second swing amount, turns back by, for example, 180° at the curved portion L12, and extends to the other side of the light receiving portion 21 by the second swing amount. Then, the third section L15 extends to the other side of the light receiving portion 21 by the first swing amount, turns back by, for example, 180° at the curved portion L12, and extends to one side of the light receiving portion 21 by the first swing amount. The meandering portion L11 is formed by repeating such movement. Additionally, each of the first section L13, the second section L14, the third section L15, and the fourth section L16 includes the curved portion L12.

The first wiring layers 31 and 32 are elongated in a direction along the first line L1 in the light receiving portion 21. That is, the length of each of the first wiring layers 31 and 32 in a direction along the first line L1 in the light receiving portion 21 is larger than the width of each of the first wiring layers 31 and 32 in a direction perpendicular to the first line L1 when viewed from the thickness direction of the first substrate 201. A direction perpendicular to the first line L1 means a direction perpendicular to a tangent line at each position of the first line L1 when viewed from the thickness direction of the first substrate 201. A direction perpendicular to the first line L1 at each position of the curved portion is different.

Specifically, the first wiring layer 31 includes a first edge portion 31a and a third edge portion 31b in the light receiving portion 21. Each of the first edge portion 31a and the third edge portion 31b extends along the first line L1 when viewed from the thickness direction of the first substrate 201. The first edge portion 31a extends at the side of the first line L1. The third edge portion 31b extends at the side opposite to the first line L1. The first wiring layer 32 includes a second edge portion 32a and a fourth edge portion 32b in the light receiving portion 21. Each of the second edge portion 32a and the fourth edge portion 32b extends along the first line L1 when viewed from the thickness direction of the first substrate 201. The second edge portion 32a extends at the side of the first line L1. The fourth edge portion 32b extends at the side opposite to the first line L1.

The first edge portion 31a and the second edge portion 32a face each other with the first line L1 interposed therebetween when viewed from the thickness direction of the first substrate 201. That is, the first gap G1 is defined by the first edge portion 31a and the second edge portion 32a when viewed from the thickness direction of the first substrate 201.

The length of each of the first wiring layers 31 and 32 in a direction along the first line L1 in the light receiving portion 21 is, for example, about several tens to several hundreds of µm when viewed from the thickness direction of the first substrate 201. The width of each of the first wiring layers 31 and 32 in a direction perpendicular to the first line L1 is, for example, about several µm when viewed from the thickness direction of the first substrate 201. The width of the first gap G1 in a direction perpendicular to the first line L1 is, for example, about several µm when viewed from the thickness direction of the first substrate 201. The thickness of each of the first wiring layers 31 and 32 is, for example, about several tens to several hundreds of nm.

The first wiring layer 31 extends from the light receiving portion 21 to the first connection portion 22 through the first beam portion 24. The first wiring layer 31 is formed on the first electrode post 7 in the first connection portion 22. The first wiring layer 31 is electrically connected to the first electrode post 7. The first wiring layer 32 extends from the light receiving portion 21 to the first connection portion 23 through the first beam portion 25. The first wiring layer 32 is formed on the first electrode post 8 in the first connection portion 23. The first wiring layer 32 is electrically connected to the first electrode post 8. The material of each of the first wiring layers 31 and 32 is, for example, a metal material such as Ti.

The insulation layer 33 is formed across the light receiving portion 21, the first beam portions 24 and 25, and the first connection portions 22 and 23 so as to cover the surface at the side opposite to the first substrate 201 in each of the first wiring layers 31 and 32. The insulation layer 33 is formed in the surface at the side opposite to the first substrate 201 in the first wiring layers 31 and 32 while an area along the first line L1 in the surface at the side opposite to the first substrate 201 in each of the first wiring layers 31 and 32 is exposed. The insulation layer 33 covers the side surface of each of the first wiring layers 31 and 32 in the first connection portions 22 and 23. The insulation layer 34 is formed across the light receiving portion 21, the first beam portions 24 and 25, and the first connection portions 22 and 23 so as to cover the surface at the side of the first substrate 201 in each of the first wiring layers 31 and 32. The insulation layer 34 enters each of the grooves 7b and 8b on the first electrode pads 62 and 63 through the outer surfaces 7a and 8a of the first electrode posts 7 and 8 and the surface at the side of the first substrate 201 in each of the first wiring layers 31 and 32 in the first connection portions 22 and 23. The thickness of each of the insulation layer 33 and the insulation layer 34 is, for example, about several tens of nm. The material of each of the insulation layer 33 and the insulation layer 34 is, for example, a silicon nitride film (SiN) or the like.

The first resistance layer 35 is formed in the light receiving portion 21 so as to cover the insulation layer 33 from the opposite side of the first substrate 201. The first resistance layer 35 contacts an area along the first line L1 in the surface at the side opposite to the first substrate 201 of each of the first wiring layers 31 and 32 in the light receiving portion 21. That is, the first resistance layer 35 is electrically connected to each of the first wiring layers 31 and 32 in the light receiving portion 21. The first resistance layer 35 has an electrical resistance depending on a temperature. The thickness of the first resistance layer 35 is, for example, about several tens to several hundreds of nm. The material of the first resistance layer 35 is, for example, amorphous silicon (a-Si) of which electrical resistivity changes greatly due to a change in temperature. In this way, the light receiving portion 21 has an electrical connection area between each of the pair of first wiring layers 31 and 32 and the first resistance layer 35. The first resistance layer 35 is provided not only in the light receiving portion 21 but also in the first connection portions 22 and 23. The first resistance layer 35 is not formed in a portion excluding both end portions of each of the first beam portions 24 and 25. That is, the first resistance layer 35 is divided in the first beam portions 24 and 25.

The light absorption layer 36 faces the first surface 201a of the first substrate 201 in the light receiving portion 21. The light absorption layer 36 is disposed at the side opposite to the first substrate 201 with respect to the first resistance layer 35. The light absorption layer 36 spreads in the entire area of the light receiving portion 21 when viewed from the thickness direction of the first substrate 201. The thickness of the light absorption layer 36 is, for example, about dozens of nm. The material of the light absorption layer 36 is, for example, WSi₂ or Ti.

The separation layer 37 is formed across the light receiving portion 21, the first and second beam portions 24 and 25, and the first and second connection portions 22 and 23 so as to be located between the first resistance layer 35 and the light absorption layer 36 in the light receiving portion 21. The thickness of the separation layer 37 is larger than the thickness of each of the first wiring layer 31, the first wiring layer 32, the first resistance layer 35, and the light absorption layer 36. The thickness of the separation layer 37 is, for example, about several hundreds of nm. The material of the separation layer 37 is, for example, a silicon nitride film (SiN) or the like.

The first membrane 20 is provided with a plurality of through-holes 20c and 20d. The plurality of through-holes 20c and 20d are holes through which an etching gas for removing a sacrificial layer 69 to be described later passes. Each of the through-holes 20c and 20d has, for example, a circular shape when viewed from the thickness direction of the first substrate 201. The diameter of each of the through-holes 20c and 20d is, for example, about several µm.

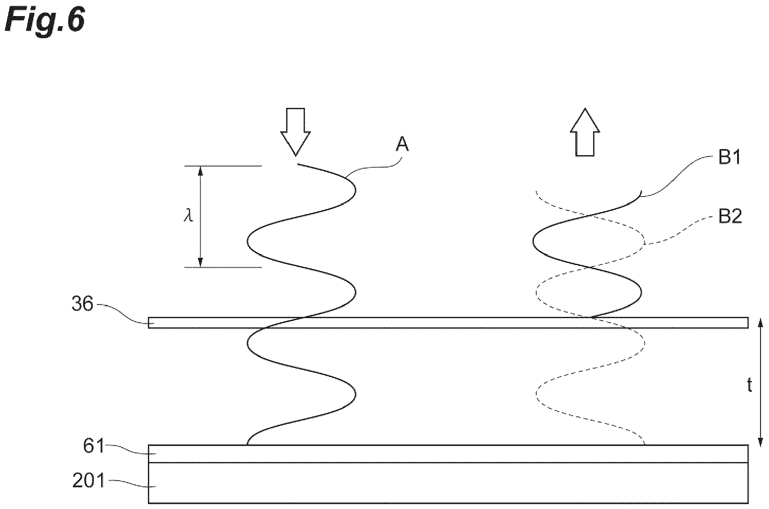

Next, an optical resonance structure will be described in detail. As illustrated in FIG. 6, a part of incident light A (having a wavelength λ) incident to the light absorption layer 36 is reflected by the light absorption layer 36 as reflected light B1 and the other is transmitted through the light absorption layer 36. Another part of the incident light A transmitted through the light absorption layer 36 is reflected by the light reflection layer 61 as reflected light B2. Then, the reflected light B1 and the reflected light B2 are canceled by interference with each other on the reflecting surface of the light absorption layer 36. Accordingly, the incident light A is absorbed in the reflecting surface of the light absorption layer 36. Heat is generated in the light absorption layer 36 due to the energy of the absorbed incident light A.

The absorption rate of the incident light A is determined by the sheet resistance of the light absorption layer 36 and the optical distance t between the light absorption layer 36 and the light reflection layer 61. The thickness of the light absorption layer 36 is set to about 16 nm so that the sheet resistance becomes a vacuum impedance (377 Ω/sq) (when the material of the light absorption layer 36 is WSi₂). Accordingly, the amplitude of the reflected light B1 reflected by the light absorption layer 36 matches the amplitude of the reflected light B2 reflected by the light reflection layer 61. For this reason, the reflected light B1 and the reflected light B2 are efficiently canceled by interference with each other on the reflecting surface of the light absorption layer 36. Thus, the absorption rate of the incident light A is improved.

Further, the optical distance t is set so as to satisfy t = (2m - 1)λ/4 (m = 1, 2, 3, ...). Accordingly, the phases of the reflected light B1 and the reflected light B2 are shifted by 180°. For this reason, the reflected light B1 and the reflected light B2 are efficiently canceled by interference with each other on the reflecting surface of the light absorption layer 36. Thus, the absorption rate of the incident light A is improved. In this way, the light reflection layer 61 constitutes an optical resonance structure along with the light absorption layer 36. The incident light A is efficiently absorbed as the area of the overlapping portion between the light reflection layer 61 and the light absorption layer 36 becomes wider when viewed from the thickness direction of the first substrate 201.

### [Configuration of Reference Element]

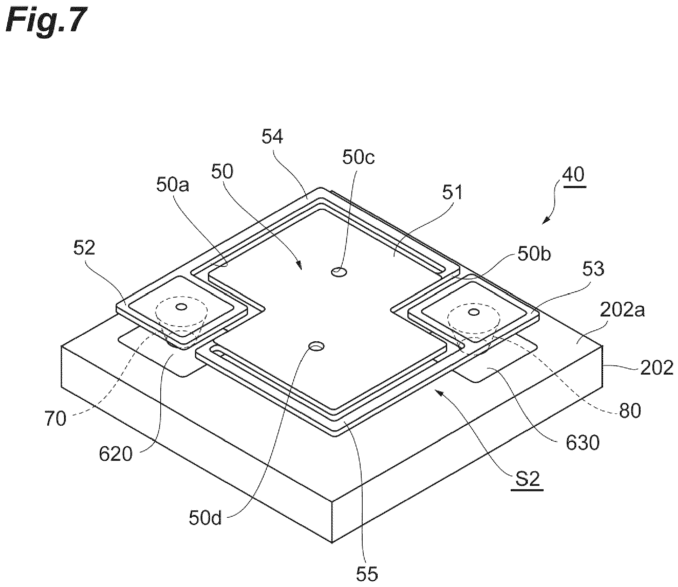

As illustrated in FIG. 7, the reference element 40 includes a second substrate 202 which is a part of the substrate 2, a pair of second electrode pads 620 and 630, a second membrane 50, a light reflection layer 96, and a pair of second electrode posts 70 and 80.

The pair of second electrode pads 620 and 630 are formed in a second surface 202a of the second substrate 202. The second electrode pads 620 and 630 are located diagonally, for example, in a rectangular shape when viewed from the thickness direction of the second substrate 202. Each of the second electrode pads 620 and 630 has, for example, a rectangular shape when viewed from the thickness direction of the second substrate 202. Each of the second electrode pads 620 and 630 is electrically connected to the signal processing circuit unit 5 through a wiring (not illustrated) formed in the second substrate 202. The thickness of each of the second electrode pads 620 and 630 is, for example, about several hundreds of nm. The material of each of the second electrode pads 620 and 630 is, for example, a conductive metal material such as Al.

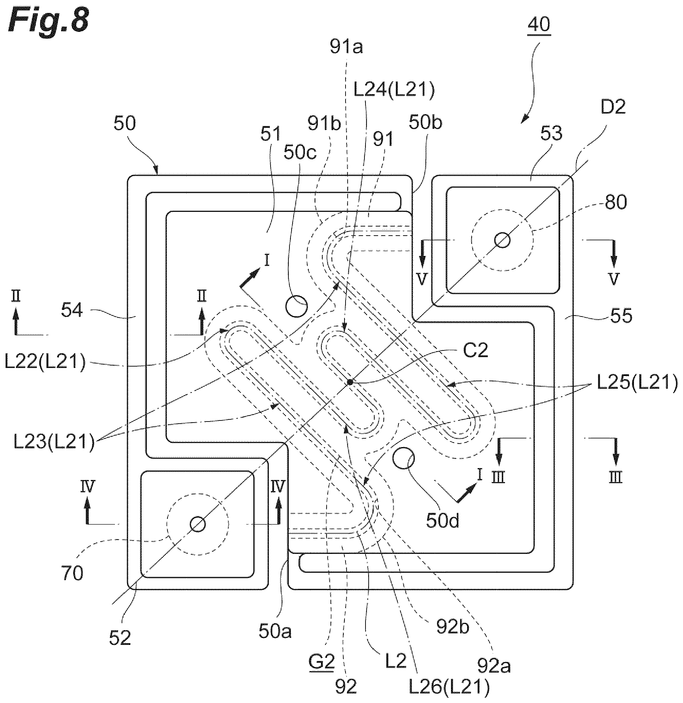

The second membrane 50 is disposed on the second surface 202a of the second substrate 202 so as to form a void space S2 between the membrane and the second surface 202a of the second substrate 202. The second membrane 50 is disposed in substantially parallel to the second surface 202a of the second substrate 202. A distance between the second membrane 50 and the second surface 202a of the second substrate 202 is, for example, about several µm. As illustrated in FIGS. 7 and 8, the second membrane 50 includes a main body portion 51, a pair of second connection portions 52 and 53, and a pair of second beam portions 54 and 55. The main body portion 51, the pair of second connection portions 52 and 53, and the pair of second beam portions 54 and 55 are integrally formed and form, for example, a rectangular outer shape when viewed from the thickness direction of the second substrate 202. The second connection portions 52 and 53 are located diagonally in the outer shape. Each of the second connection portions 52 and 53 has, for example, a rectangular shape when viewed from the thickness direction of the second substrate 202. In this way, in the light detector 1, the outer shape of the second membrane 50 when viewed from the thickness direction of the second substrate 202 is formed in a rectangular shape by the main body portion 51, the pair of second connection portions 52 and 53, and the pair of second beam portions 54 and 55. Additionally, the outer shape of the second membrane 50 when viewed from the thickness direction of the second substrate 202 is an entire outer shape of the second membrane 50 including the main body portion 51, the pair of second connection portions 52 and 53, the pair of second beam portions 54 and 55, and second slits 50a and 50b to be described later.

The main body portion 51 faces the second surface 202a of the second substrate 202 in the thickness direction of the second substrate 202. The second connection portion 52 faces the second electrode pad 620 in the thickness direction of the second substrate 202. The second connection portion 53 faces the second electrode pad 630 in the thickness direction of the second substrate 202.

The second beam portion 54 is disposed between the main body portion 51 and the second connection portion 52. The second beam portion 54 extends along the outer edge of the main body portion 51 at one side of the main body portion 51. One end of the second beam portion 54 is connected to the second connection portion 52 and the other end of the second beam portion 54 is connected to the main body portion 51 at a position in the vicinity of the second connection portion 53. The second slits 50a are continuously formed between the main body portion 51 and the second connection portion 52 and between the main body portion 51 and the second beam portion 54. The second beam portion 55 is disposed between the main body portion 51 and the second connection portion 53. The second beam portion 55 extends along the outer edge of the main body portion 51 at the other side of the main body portion 51. One end of the second beam portion 55 is connected to the second connection portion 53 and the other end of the second beam portion 55 is connected to the main body portion 51 at a position in the vicinity of the second connection portion 52. The second slits 50b are continuously formed between the main body portion 51 and the second connection portion 53 and between the main body portion 51 and the second beam portion 55. The width of each of the second beam portions 54 and 55 is, for example, about several µm. The length of each of the second beam portions 54 and 55 is, for example, about several tens to several hundreds of µm. The width of each of the second slits 50a and 50b is, for example, about several µm.

The light reflection layer 96 is formed in the surface at the side opposite to the second substrate 202 in the second membrane 50. The light reflection layer 96 is formed on the main body portion 51. The light reflection layer 96 spreads over the entire area of the main body portion 51 when viewed from the thickness direction of the second substrate 202. The thickness of the light reflection layer 96 is, for example, about several hundreds of nm. The material of the light reflection layer 96 is, for example, a metal material such as Al having high reflectivity with respect to light (for example, infrared light).

The second electrode post 70 is disposed between the second substrate 202 and the second connection portion 52. Specifically, the second electrode post 70 is disposed between the second electrode pad 620 and the second connection portion 52. The second electrode post 70 has a tubular shape spreading from the second electrode pad 620 toward the side opposite to the second substrate 202. An outer surface 70a of the second electrode post 70 is provided with a groove 70b extending in an annular shape along the outer edge thereof. The groove 70b is defined by the second electrode post 70 and the second electrode pad 620. The second electrode post 70 supports the second membrane 50 and is electrically connected to the second wiring layer 91 (to be described later in detail) of the second membrane 50 and the second electrode pad 620. The second electrode post 80 is disposed between the second substrate 202 and the second connection portion 53. Specifically, the second electrode post 80 is disposed between the second electrode pad 630 and the second connection portion 53. The second electrode post 80 has a tubular shape spreading from the second electrode pad 630 toward the side opposite to the second substrate 202. An outer surface 80a of the second electrode post 80 is provided with a groove 80b extending in an annular shape along the outer edge thereof. The groove 80b is defined by the second electrode post 80 and the second electrode pad 630. The second electrode post 80 supports the second membrane 50 and is electrically connected to the second wiring layer 92 (to be described later in detail) of the second membrane 50 and the second electrode pad 630. The height of each of the second electrode posts 70 and 80 is, for example, about several µm. The material of each of the second electrode posts 70 and 80 is, for example, a metal material such as Ti.

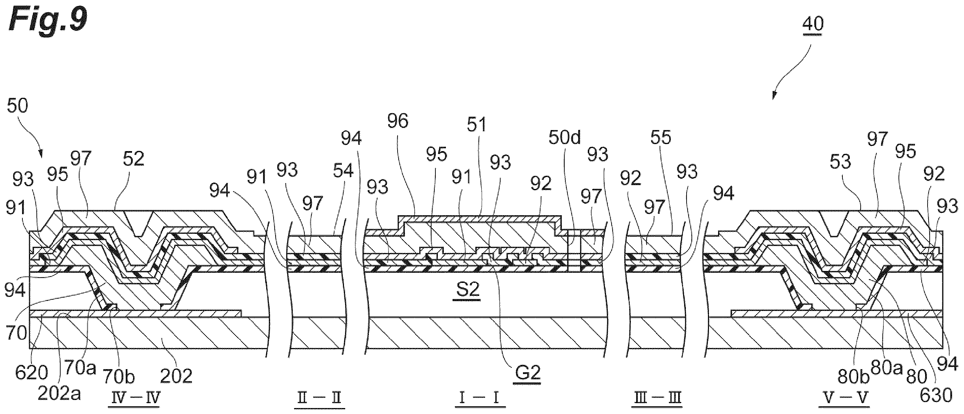

FIG. 9 is a cross-sectional view of the reference element 40. I-I, II-II, III-III, IV-IV, and V-V of FIG. 9 are respectively cross-sectional views taken along lines of I-I, II-II, III-III, IV-IV, and V-V of FIG. 8. As illustrated in FIG. 9, the second membrane 50 includes a pair of second wiring layers 91 and 92, insulation layers 93 and 94, a second resistance layer 95, and a separation layer 97.

As illustrated in FIGS. 8 and 9, the second wiring layers 91 and 92 face each other with the second gap G2 interposed therebetween in the main body portion 51 when viewed from the thickness direction of the second substrate 202. The second gap G2 extends along the second line L2. The second line L2 extends between the diagonals facing each other with the geometric center position C2 of the second membrane 50 interposed therebetween when viewed from the thickness direction of the second substrate 202. Specifically, the second line L2 extends in a meandering manner along a second diagonal line D2 passing through the geometric center position C2 of the second membrane 50 and connecting the second connection portions 52 and 53 when viewed from the thickness direction of the second substrate 202. The second line L2 includes a meandering portion L21. The meandering portion L21 includes a plurality of curved portions L22. The meandering portion L21 is formed in the main body portion 51 so as to extend to one side of the main body portion 51, turn back by, for example, 180° at the curved portion L22, extend to the other side of the main body portion 51, turn back by, for example, 180° at the curved portion L22, and extend to one side of the main body portion 51 again in a repeated manner.

In the reference element 40, one side means one side (for example, the existence side of the second beam portion 54) with respect to the second diagonal line D2 when viewed from the thickness direction of the second substrate 202 and the other side means the side (for example, the existence side of the second beam portion 55) opposite to one side with respect to the second diagonal line D2 when viewed from the thickness direction of the second substrate 202.

The meandering portion L21 includes a fifth section L23, a sixth section L24, a seventh section L25, and an eighth section L26 when viewed from the thickness direction of the second substrate 202. The fifth section L23 swings to one side by a third swing amount. The sixth section L24 swings to one side by a fourth swing amount. The sixth section L24 is sandwiched between two fifth sections L23 in a direction along the second diagonal line D2 when viewed from the thickness direction of the second substrate 202. The seventh section L25 swings to the other side by the third swing amount. The eighth section L26 swings to the other side by the fourth swing amount. The eighth section L26 is sandwiched between two seventh sections L25 in a direction along the second diagonal line D2 when viewed from the thickness direction of the second substrate 202. The third swing amount is larger than a predetermined amount. The fourth swing amount is smaller than a predetermined amount. The third swing amount is, for example, about dozens of µm. The fourth swing amount is, for example, about several µm.

Specifically, in the main body portion 51, the fifth section L23 extends to one side of the main body portion 51 by the third swing amount, turns back by, for example, 180° at the curved portion L22, and extends to the other side of the main body portion 51 by the third swing amount. Then, the eighth section L26 extends to the other side of the main body portion 51 by the fourth swing amount, turns back by, for example, 180° at the curved portion L22, and extends to one side of the main body portion 51 by the fourth swing amount. Then, the sixth section L24 extends to one side of the main body portion 51 by the fourth swing amount, turns back by, for example, 180° at the curved portion L22, and extends to the other side of the main body portion 51 by the fourth swing amount. Then, the seventh section L25 extends to the other side of the main body portion 51 by the third swing amount, turns back by, for example, 180° at the curved portion L22, and extends to one side of the main body portion 51 by the third swing amount. The meandering portion L21 is formed by repeating such movement. Additionally, each of the fifth section L23, the sixth section L24, the seventh section L25, and the eighth section L26 includes the curved portion L22.

The second wiring layers 91 and 92 are formed in the main body portion 51 so as to be elongated in a direction along the second line L2. That is, the length of each of the second wiring layers 91 and 92 in a direction along the second line L2 in the main body portion 51 is larger than the width of each of the second wiring layers 91 and 92 in a direction perpendicular to the second line L2 when viewed from the thickness direction of the second substrate 202. A direction perpendicular to the second line L2 means a direction perpendicular to a tangent line at each position of the second line L2 when viewed from the thickness direction of the second substrate 202. A direction perpendicular to the second line L2 at each position of the curved portion is different.

Specifically, the second wiring layer 91 includes a fifth edge portion 91a and a seventh edge portion 91b in the main body portion 51. Each of the fifth edge portion 91a and the seventh edge portion 91b extends along the second line L2 when viewed from the thickness direction of the second substrate 202. The fifth edge portion 91a extends at the side of the second line L2. The seventh edge portion 91b extends at the side opposite to the second line L2. The second wiring layer 92 includes a sixth edge portion 92a and an eighth edge portion 92b in the main body portion 51. Each of the sixth edge portion 92a and the eighth edge portion 92b extends along the second line L2 when viewed from the thickness direction of the second substrate 202. The sixth edge portion 92a extends at the side of the second line L2. The eighth edge portion 92b extends at the side opposite to the second line L2.

The fifth edge portion 91a and the sixth edge portion 92a face each other with the second line L2 interposed therebetween when viewed from the thickness direction of the second substrate 202. That is, the second gap G2 is defined by the fifth edge portion 91a and the sixth edge portion 92a when viewed from the thickness direction of the second substrate 202.

The length of each of the second wiring layers 91 and 92 in a direction perpendicular to the second line L2 in the main body portion 51 when viewed from the thickness direction of the second substrate 202 is, for example, about several tens to several hundreds of µm. The width of each of the second wiring layers 91 and 92 in a direction perpendicular to the second line L2 when viewed from the thickness direction of the second substrate 202 is, for example, about several µm. The width of the second gap G2 in a direction perpendicular to the second line L2 when viewed from the thickness direction of the second substrate 202 is, for example, about several µm. The thickness of each of the second wiring layers 91 and 92 is, for example, about several tens to several hundreds of nm.

The second wiring layer 91 extends from the main body portion 51 toward the second connection portion 52 through the second beam portion 54. The second wiring layer 91 is formed on the second electrode post 70 in the second connection portion 52. The second wiring layer 91 is electrically connected to the second electrode post 70. The second wiring layer 92 extends from the main body portion 51 toward the second connection portion 53 through the second beam portion 55. The second wiring layer 92 is formed on the second electrode post 80 in the second connection portion 53. The second wiring layer 92 is electrically connected to the second electrode post 80. The material of each of the second wiring layers 91 and 92 is, for example, a metal material such as Ti.

The insulation layer 93 is formed across the main body portion 51, the second beam portions 54 and 55, and the second connection portions 52 and 53 so as to cover the surface at the side opposite to the second substrate 202 in each of the second wiring layers 91 and 92. The insulation layer 93 is formed in the surface at the side opposite to the second substrate 202 in the second wiring layers 91 and 92 while an area along the second line L2 in the surface at the side opposite to the second substrate 202 in each of the second wiring layers 91 and 92 is exposed. The insulation layer 93 covers the side surface of each of the second wiring layers 91 and 92 in the second connection portions 52 and 53. The insulation layer 94 is formed across the main body portion 51, the second beam portions 54 and 55, and the second connection portions 52 and 53 so as to cover the surface at the side of the second substrate 202 in each of the second wiring layers 91 and 92. The insulation layer 94 enters each of the grooves 70b and 80b on the second electrode pads 620 and 630 through the outer surfaces 70a and 80a of the second electrode posts 70 and 80 and the surface at the side of the second substrate 202 in each of the second wiring layers 91 and 92 in the second connection portions 52 and 53. The thickness of each of the insulation layer 93 and the insulation layer 94 is, for example, about several tens of nm. The material of each of the insulation layer 93 and the insulation layer 94 is, for example, a silicon nitride film (SiN) or the like.

The second resistance layer 95 is formed in the main body portion 51 so as to cover the insulation layer 93 from the side opposite to the second substrate 202. The second resistance layer 95 contacts an area along the second line L2 in the surface at the side opposite to the second substrate 202 in each of the second wiring layers 91 and 92 in the main body portion 51. That is, the second resistance layer 95 is electrically connected to each of the second wiring layers 91 and 92 in the main body portion 51. The second resistance layer 95 has an electrical resistance depending on a temperature. The thickness of the second resistance layer 95 is, for example, about several tens to several hundreds of nm. The material of the second resistance layer 95 is, for example, amorphous silicon (a-Si) or the like having a large change in electrical resistivity due to a change in temperature. In this way, the main body portion 51 has an electrical connection area between each of the pair of second wiring layers 91 and 92 and the second resistance layer 95. The second resistance layer 95 is provided not only in the main body portion 51 but also in the second connection portions 52 and 53. The second resistance layer 95 is not formed in a portion excluding both end portions of each of the second beam portions 54 and 55. That is, the second resistance layer 95 is divided in the second beam portions 54 and 55.

The separation layer 97 is formed across the main body portion 51, the second beam portions 54 and 55, and the second connection portions 52 and 53 so as to be located between the second resistance layer 95 and the light reflection layer 96 in the main body portion 51. The thickness of the separation layer 97 is larger than the thickness of each of the second wiring layer 91, the second wiring layer 92, the second resistance layer 95, and the light reflection layer 96. The thickness of the separation layer 97 is, for example, about several hundreds of nm. The material of the separation layer 97 is, for example, a silicon nitride film (SiN) or the like.

The second membrane 50 is provided with a plurality of through-holes 50c and 50d. The plurality of through-holes 50c and 50d are holes through which an etching gas for removing a sacrificial layer used in the process of manufacturing the reference element 40 passes. Each of the through-holes 50c and 50d has, for example, a circular shape when viewed from the thickness direction of the second substrate 202. The diameter of each of the through-holes 50c and 50d is, for example, about several µm.

### [Operation of Light Detector]

In the light detector 1 with the above-described configuration, light is detected as below. First, when light is incident to the light receiving portion 21 of the light detecting element 10, heat is generated in the light absorption layer 36 constituting the above-described optical resonance structure. At this time, the light receiving portion 21 and the first substrate 201 are thermally separated from each other by the void space S1. Further, the light receiving portion 21, the first connection portion 22, and the first beam portion 24 are thermally separated from one another by the first slit 20a. Further, the light receiving portion 21, the first connection portion 23, and the first beam portion 25 are thermally separated from one another by the first slit 20b. For this reason, it is possible to suppress that heat generated in the light absorption layer 36 escapes to the substrate 2 through the first beam portions 24 and 25 and the first connection portions 22 and 23. Further, the light absorption layer 36 and the first wiring layers 31 and 32 are thermally separated from one another by the separation layer 37. For this reason, it is possible to suppress that heat generated in the light absorption layer 36 escapes to the first substrate 201 through the first wiring layers 31 and 32 before the heat is sufficiently transmitted to the first resistance layer 35 through the separation layer 37.

Heat generated in the light absorption layer 36 is transmitted to the first resistance layer 35 through the separation layer 37. Then, the temperature and the electrical resistance of the first resistance layer 35 increase due to the heat. A change in electrical resistance is transmitted as a signal to the signal processing circuit unit 5 through the first wiring layers 31 and 32 and the first electrode posts 7 and 8. In the signal processing circuit unit 5, a change in electrical resistance of the first resistance layer 35 is converted into a change in voltage or current. At this time, a change in electrical resistance is also transmitted as a signal from the reference element 40 of the reference unit 4 to the signal processing circuit unit 5. In the signal processing circuit unit 5, a change in electrical resistance of the second resistance layer 95 of the reference element 40 is converted into a change in voltage or current. In the signal processing circuit unit 5, light is detected on the basis of a difference between a change in voltage or current by the light detecting element 10 and a change in voltage or current by the reference element 40. Additionally, the signal in one reference element 40 is transmitted to the signal processing circuit unit 5 whenever the signal of each of the plurality of corresponding light detecting elements 10 is transmitted to the signal processing circuit unit 5. That is, the number of times of transmitting the signal from the reference element 40 is larger than the number of times of transmitting the signal from the light detecting element 10. For this reason, the reference element 40 easily deteriorates as compared with the light detecting element 10.

### [Operation and Effect]

As described above, in the light detector 1, the pair of second wiring layers 91 and 92 face each other through the second gap G2 extending between the diagonals facing each other with the geometric center position C2 of the second membrane 50 interposed therebetween in the reference element 40. For this reason, the pair of second wiring layers 91 and 92 can support the second membrane 50 in a more balanced manner as compared with a case in which the second gap G2 extends at a position other than between the diagonals. Accordingly, the deformation (curvature, bending, or the like) of the second membrane 50 is suppressed. Thus, according to the light detector 1, compensation accuracy by the reference element 40 can be secured. As described above, such an effect is particularly noticeable when one reference element 40 is used for the compensation of the plurality of light detecting elements 10.

Further, in the light detector 1, the second line L2 extends in a meandering manner when viewed from the thickness direction of the second substrate 202. According to this configuration, the pair of second wiring layers 91 and 92 facing each other through the second gap G2 extending along the second line L2 are more widely distributed. For this reason, the pair of second wiring layers 91 and 92 can support the second membrane 50 in a more balanced manner. Accordingly, the deformation of the second membrane 50 is more reliably suppressed. For this reason, it is possible to more reliably secure compensation accuracy by the reference element.

Further, in the light detector 1, the light reflection layer 96 is formed in the surface at the side opposite to the second substrate 202 in the second membrane 50. According to this configuration, since it is possible to prevent light from being incident to the second membrane 50, it is possible to easily and reliably exhibit a function for compensating a change in temperature due to a factor other than the receiving of light in the light detecting element 10 by the reference element 40.

Further, in the light detector 1, the outer shape of the first membrane 20 when viewed from the thickness direction of the first substrate 201 is a polygonal shape and the first line L1 extends between the diagonals facing each other with the geometric center position C1 of the first membrane 20 interposed therebetween when viewed from the thickness direction of the first substrate 201. According to this configuration, the pair of first wiring layers 31 and 32 can support the first membrane 20 in a more balanced manner as compared with a case in which the first gap G1 extends at a position other than between the diagonals. Accordingly, the deformation (curvature, bending, or the like) of the first membrane 20 is suppressed. Thus, it is possible to exhibit a function for detecting light on the basis of a change in temperature due to the receiving of light by the light detecting element 10.

### [Light Detecting Element Manufacturing Method]

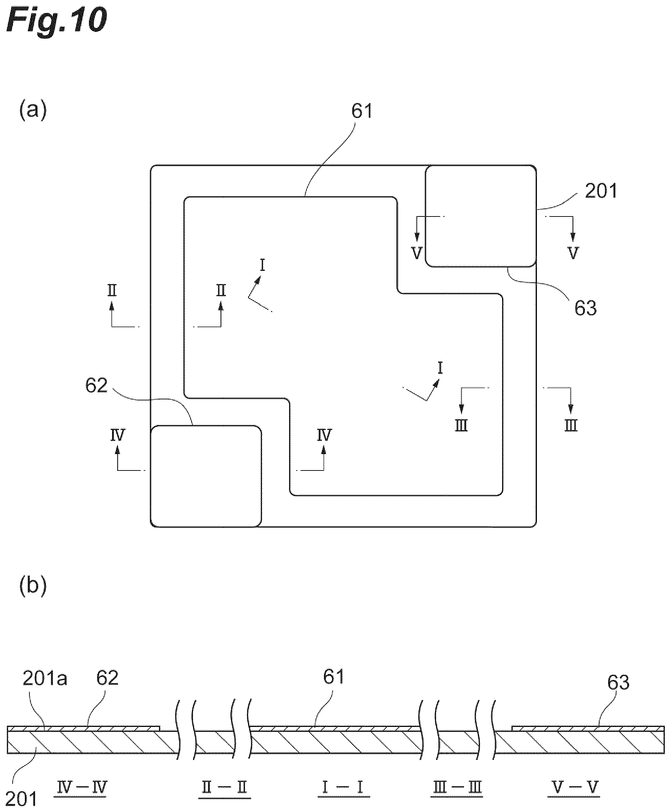

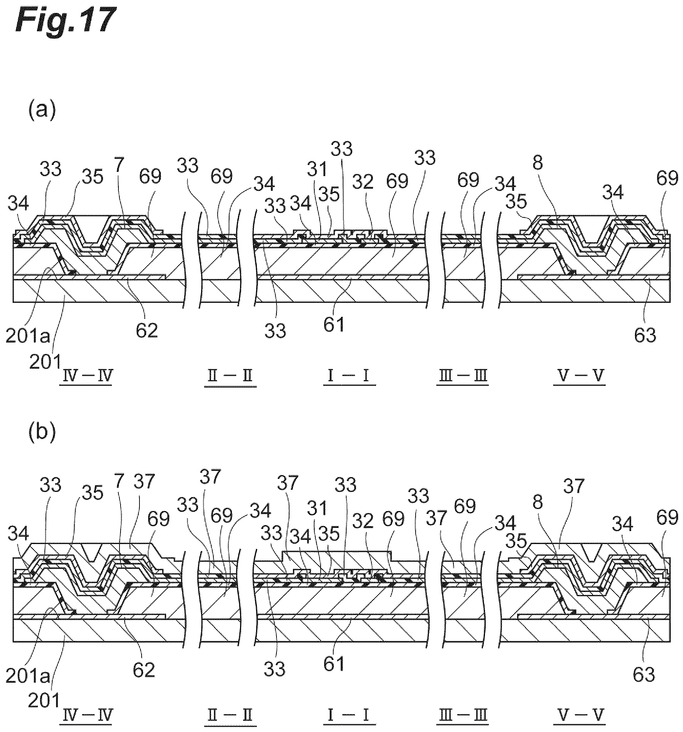

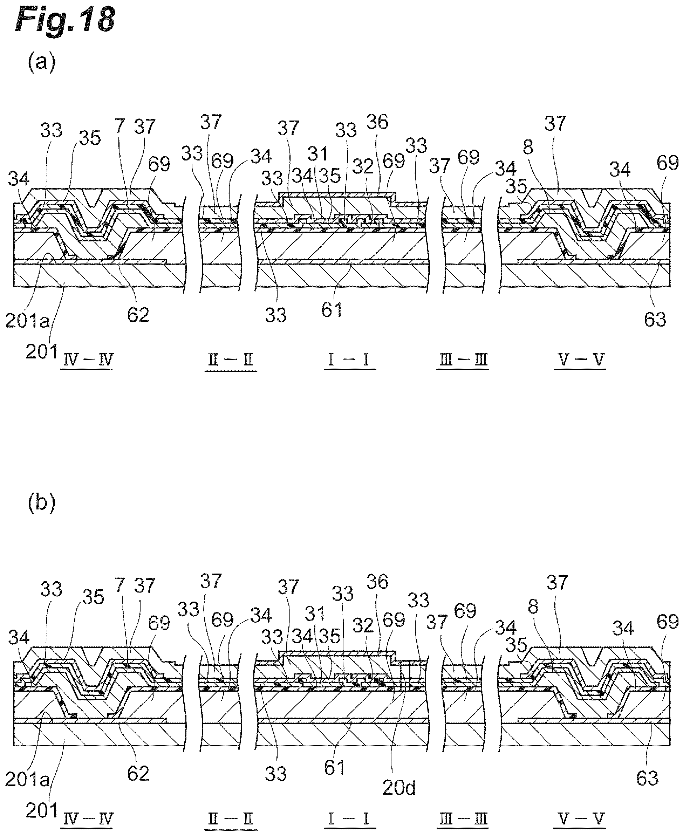

Next, a method of manufacturing the light detecting element 10 will be described with reference to FIGS. 10 to 19. In the drawings of FIGS. 10 to 16 and FIG. 19, I-I, II-II, III-III, IV-IV, and V-V of (b) are respectively cross-sectional views taken along lines I-I, II-II, III-III, IV-IV, and V-V of (a). In FIGS. 17 and 18, a drawing like (a) is omitted.

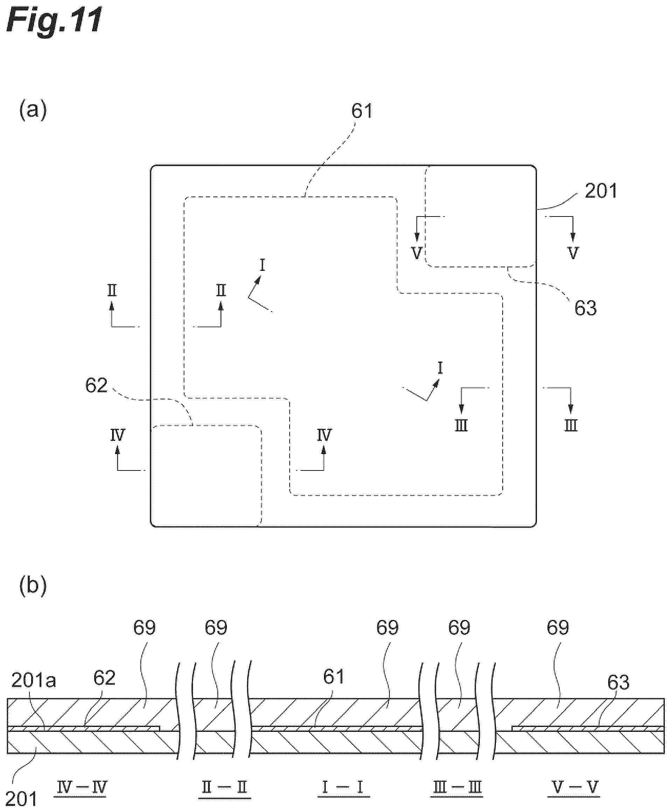

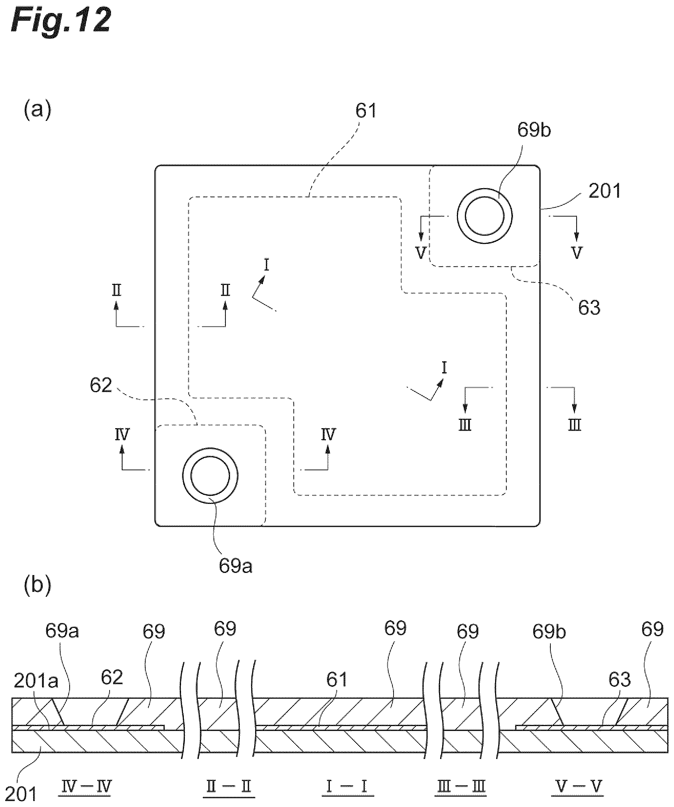

First, as illustrated in FIG. 10, the first substrate 201 is prepared and the light reflection layer 61, the first electrode pad 62, and the first electrode pad 63 are formed in the first surface 201a of the first substrate 201. The light reflection layer 61, the first electrode pad 62, and the first electrode pad 63 are formed in the above-described shape by etching. Next, as illustrated in FIG. 11, the sacrificial layer 69 is formed in the first surface 201a of the first substrate 201 so as to cover the light reflection layer 61, the first electrode pad 62, and the first electrode pad 63. The material of the sacrificial layer 69 is, for example, polyimide or the like. Next, as illustrated in FIG. 12, a part of the sacrificial layer 69 is removed by etching so as to form the through-holes 69a and 69b in the sacrificial layer 69. The through-holes 69a and 69b are respectively formed on the first electrode pad 62 and the first electrode pad 63. Then, in each of the through-holes 69a and 69b, the surface at the side opposite to the first substrate 201 in each of the first electrode pad 62 and the first electrode pad 63 is exposed. The inner surface of each of the through-holes 69a and 69b is, for example, a truncated cone-shaped tapered surface. The inner surfaces of the through-holes 69a and 69b respectively spread from the first electrode pad 62 and the first electrode pad 63 toward the side opposite to the first substrate 201.

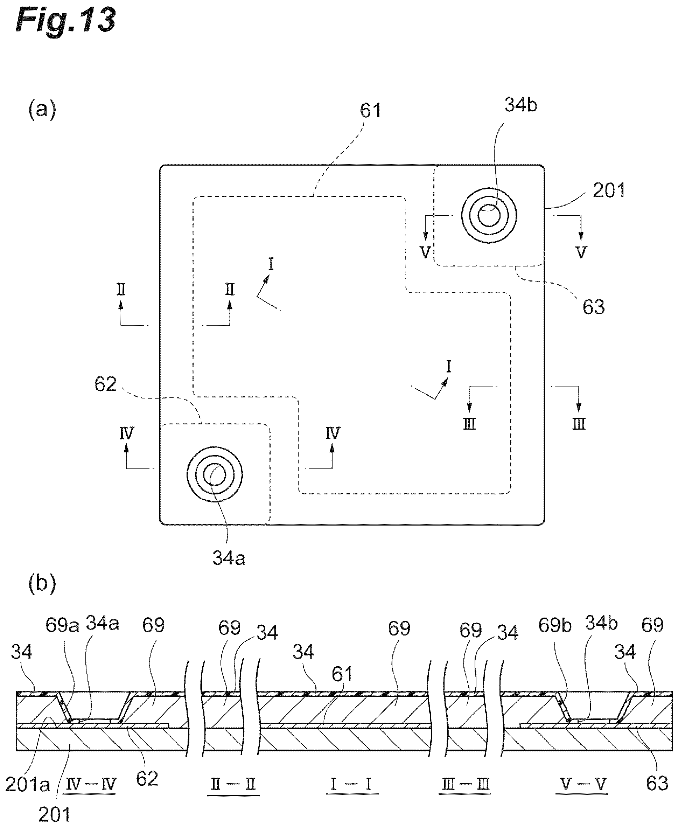

Next, as illustrated in FIG. 13, the insulation layer 34 is formed on the sacrificial layer 69. The insulation layer 34 is formed so that the inner surface of each of the through-holes 69a and 69b is formed as, for example, a truncated cone-shaped tapered surface. Next, a part of the insulation layer 34 is removed by etching so as to form the through-holes 34a and 34b in the insulation layer 34. The through-holes 34a and 34b are respectively formed on the first electrode pad 62 and the first electrode pad 63. Then, in each of the through-holes 34a and 34b, the surface at the side opposite to the first substrate 201 in each of the first electrode pad 62 and the first electrode pad 63 is exposed. Each of the through-holes 34a and 34b has a circular shape when viewed from the thickness direction of the first substrate 201.

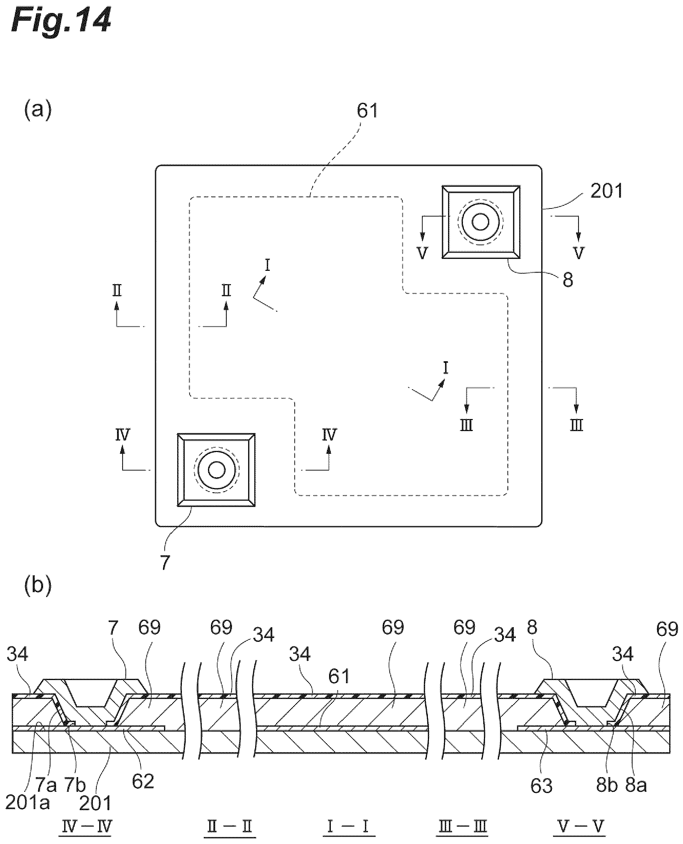

Next, as illustrated in FIG. 14, the first electrode post 7 is formed on the insulation layer 34 in the through-hole 69a and the first electrode post 8 is formed on the insulation layer 34 in the through-hole 69b. Each of the first electrode posts 7 and 8 is formed by, for example, vapor deposition. At this time, since the insulation layer 34 is formed so that the inner surface of each of the through-holes 69a and 69b is a tapered surface, each of the first electrode posts 7 and 8 is more reliably formed. Accordingly, disconnection due to the poor film formation of the first electrode posts 7 and 8 is suppressed. Thus, it is possible to suppress an electrical connection error in each of the first connection portion 22 and the first connection portion 23. Further, a variation in thickness of each of the first electrode posts 7 and 8 is suppressed and the strength is stabilized. Moreover, since the insulation layer 34 includes a portion entering each of the groove 7b and the groove 8b in each of the first connection portion 22 and the first connection portion 23, the allowable range of misalignment of the first electrode posts 7 and 8 is widened. Each of the first electrode posts 7 and 8 is formed so that the inner surface is, for example, a truncated cone-shaped tapered surface on the insulation layer 34 in each of the through-holes 69a and 69b.

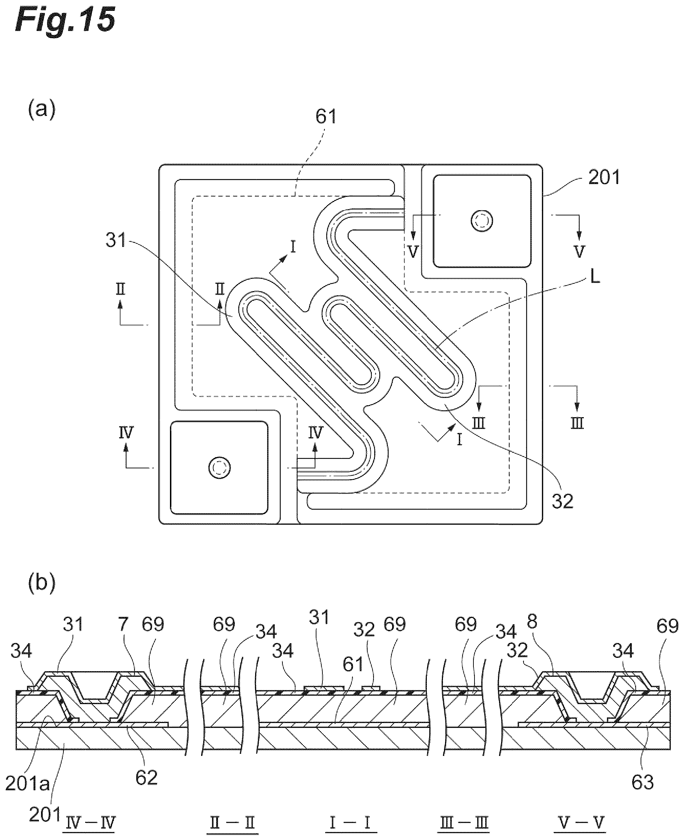

Next, as illustrated in FIG. 15, the first wiring layers 31 and 32 are formed on the insulation layer 34 so as to cover the first electrode posts 7 and 8. Each of the first wiring layers 31 and 32 is formed by, for example, vapor deposition. At this time, since the inner surface of each of the first electrode posts 7 and 8 is a tapered surface, the first wiring layers 31 and 32 are more reliably formed on the first electrode posts 7 and 8. Accordingly, disconnection due to the poor film formation of the first wiring layers 31 and 32 is suppressed. Thus, it is possible to suppress an electrical connection error in each of the first connection portion 22 and the first connection portion 23. Further, a variation in thickness of each of the first wiring layers 31 and 32 is suppressed and the strength is stabilized. Additionally, since the plurality of light detecting elements 10 are arranged in a two-dimensional matrix shape, an effect of more reliably forming the first electrode posts 7 and 8 and the first wiring layers 31 and 32 is more noticeable when the aspect ratio of the first electrode posts 7 and 8 is increased in order to reduce the pitch of the pixel and the dead space. The first wiring layers 31 and 32 are formed in the above-described shape by etching.

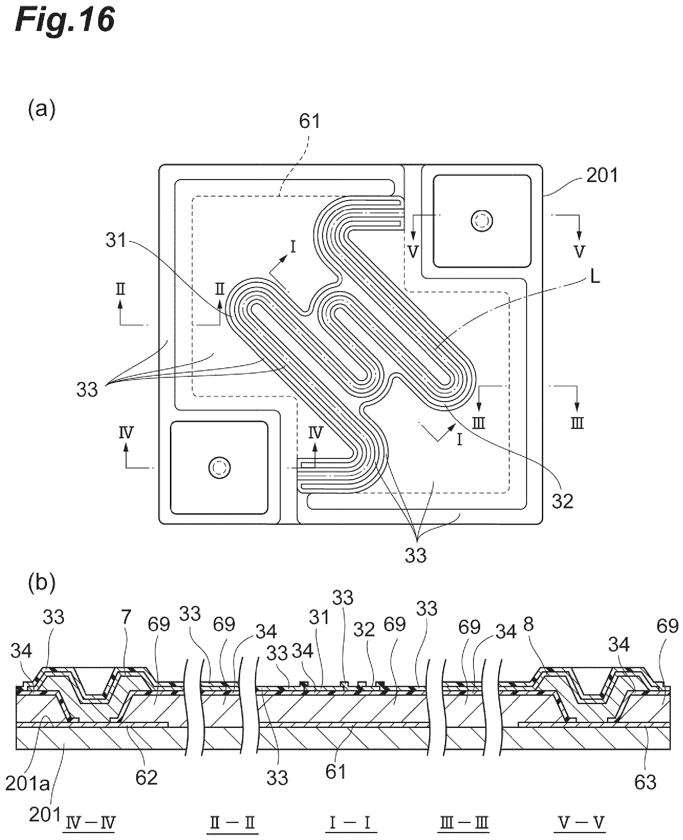

Next, as illustrated in FIG. 16, the insulation layer 33 is formed across the light receiving portion 21, the first beam portions 24 and 25, and the first connection portions 22 and 23 so as to cover the first wiring layers 31 and 32 from the opposite side of the first substrate 201. The insulation layer 33 is formed in the above-described shape by etching. Next, as illustrated in FIG. 17, the first resistance layer 35 is formed in the light receiving portion 21 so as to cover the insulation layer 33 from the opposite side of the first substrate 201 and the first resistance layer 35 is formed on the insulation layer 33 in the first connection portion 22 and the first connection portion 23. Then, the separation layer 37 is formed in the light receiving portion 21, the first connection portion 22, and the first connection portion 23 so as to cover the first resistance layer 35 from the opposite side of the first substrate 201 and the separation layer 37 is formed on the insulation layer 33 in the first beam portion 24 and the first beam portion 25.

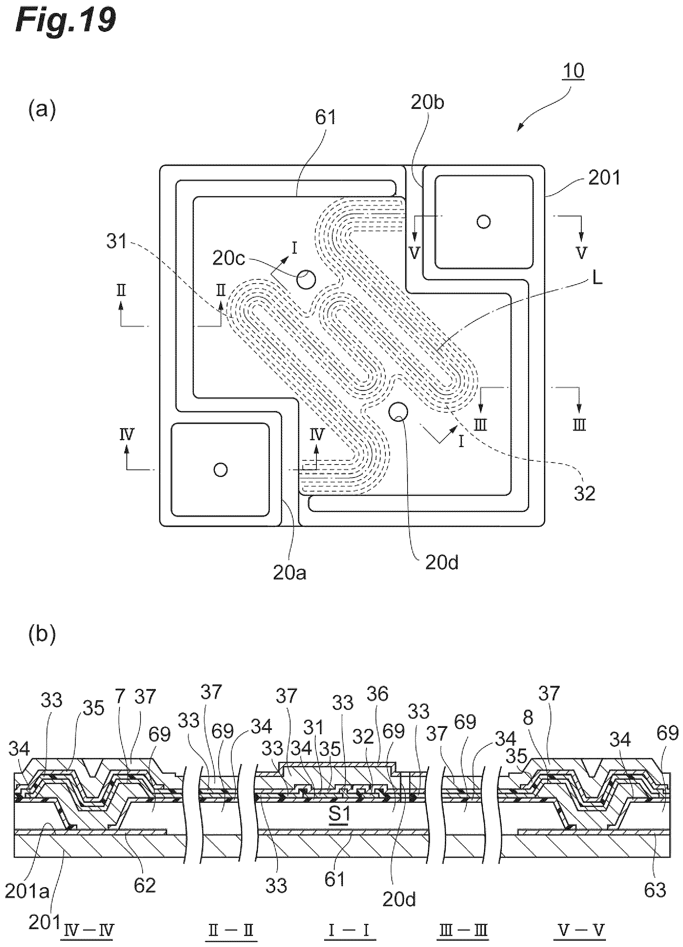

Next, as illustrated in FIG. 18, the light absorption layer 36 is formed on the separation layer 37 in the light receiving portion 21 and the through-holes 20c and 20d are further formed. The light absorption layer 36 is formed in the above-described shape by etching. The through-holes 20c and 20d are formed at the above-described positions by etching. Next, as illustrated in FIG. 19, the first slits 20a and 20b are formed and the sacrificial layer 69 is formed by performing etching from the first slits 20a and 20b and the through-holes 20c and 20d so as to form the void space S1. The first slits 20a and 20b are formed at the above-described positions by etching.

Additionally, the method of manufacturing the reference element 40 is different from the method of manufacturing the light detecting element 10 in that the light reflection layer 96 is formed on the separation layer 97 instead of forming the light absorption layer 36 on the separation layer 37 and the light reflection layer 61 is not formed. Additionally, the plurality of light detecting elements 10 arranged in a two-dimensional matrix shape and the plurality of reference element 40 arranged in one dimension are manufactured on the substrate 2 at the same time.

As described above, an embodiment of the present disclosure has been described, but the present disclosure is not limited to the above-described embodiment.

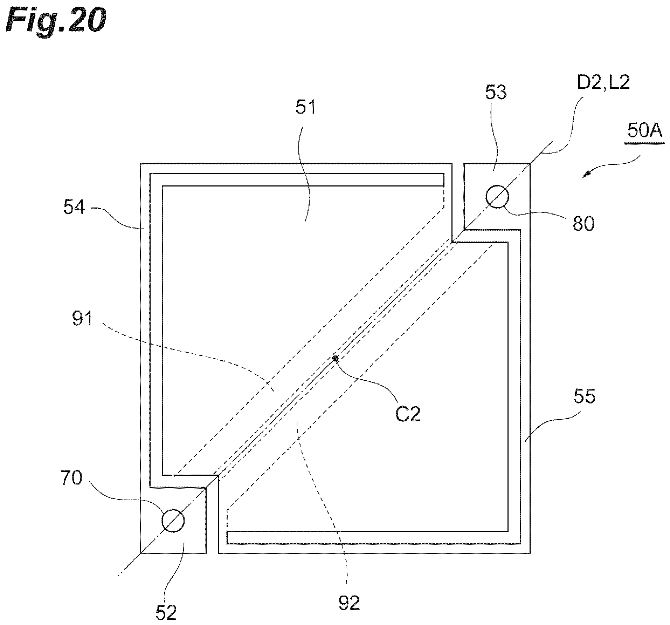

FIGS. 20 to 29 illustrate a second membrane 50A to a second membrane 50J as a modified example of the second membrane 50 of the reference element 40. As illustrated in FIG. 20, in the second membrane 50A, the second line L2 may not extend in a meandering manner when viewed from the thickness direction of the substrate 2. The second line L2 may extend between the diagonals facing each other with the geometric center position C2 of the second membrane 50 interposed therebetween when viewed from the thickness direction of the substrate 2. The second line L2 may overlap, for example, the second diagonal line D2.

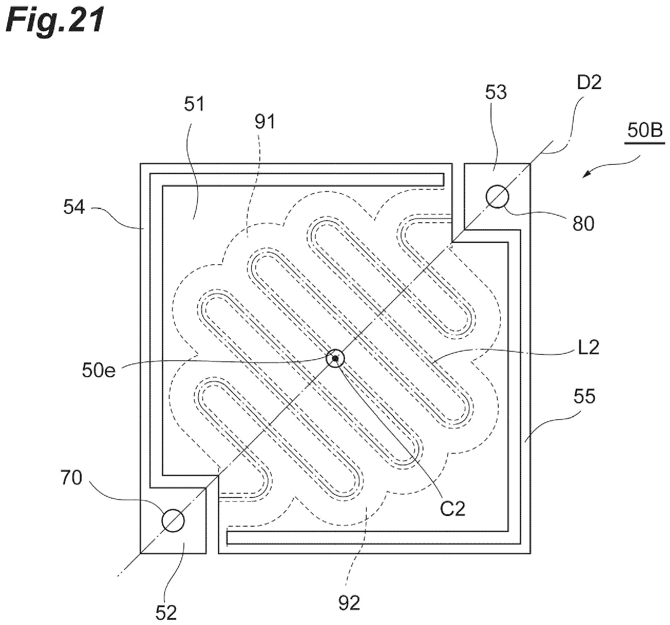

Further, as illustrated in FIG. 21, in the second membrane 50B, the second line L2 may extend in a meandering manner in the substantially entire area of the main body portion 51 when viewed from the thickness direction of the substrate 2. Further, the main body portion 51 may be provided with one through-hole 50e. The through-hole 50e may be formed at the geometric center position C2 of the second membrane 50.

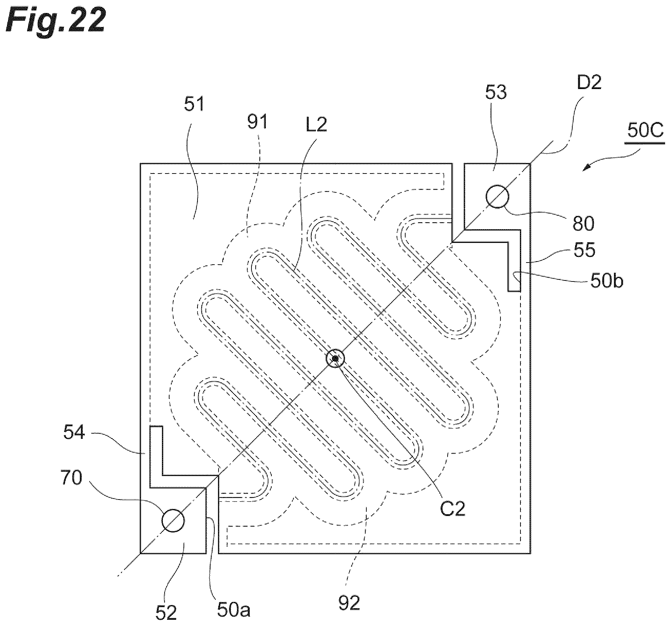

Further, as illustrated in FIG. 22, in the second membrane 50C, the length of each of the pair of second beam portions 54 and 55 may be shorter than the length of each of the pair of first beam portions 24 and 25. According to this configuration, since the deformation of the second membrane 50C of the reference element 40 is suppressed as compared with the first membrane 20 of the light detecting element 10, it is possible to more reliably secure compensation accuracy by the reference element 40.

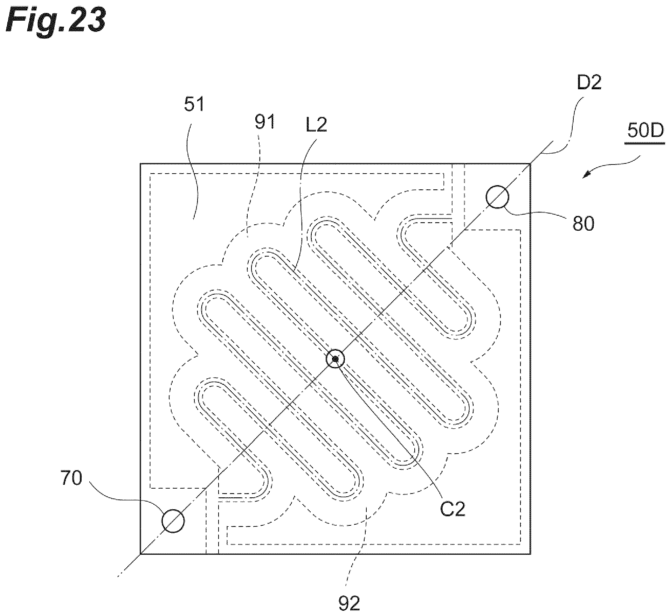

Further, as illustrated in FIG. 23, the outer shape of the second membrane 50D when viewed from the thickness direction of the substrate 2 may be formed in a polygonal shape (here, a rectangular shape) by the main body portion 51 and the pair of second electrode posts 70 and 80 may be disposed between the substrate 2 and each of the pair of corner portions of the main body portion 51. That is, the second membrane 50D does not include the second connection portion and the second beam portion and may be formed only along the main body portion 51. According to this configuration, since the deformation of the second membrane 50D of the reference element 40 is suppressed as compared with the first membrane 20 of the light detecting element 10, it is possible to more reliably secure compensation accuracy by the reference element 40.

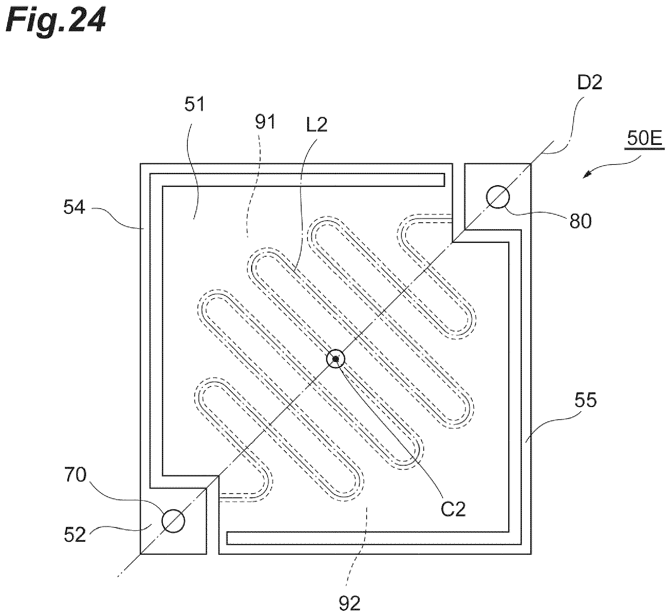

Further, as illustrated in FIG 24, in the second membrane 50E, the second wiring layer 91 may spread toward the side opposite to the second wiring layer 92 with respect to the second gap G2 when viewed from the thickness direction of the substrate 2 and the second wiring layer 92 may spread toward the side opposite to the second wiring layer 91 with respect to the second gap G2 when viewed from the thickness direction of the substrate 2. According to this configuration, since the deformation of the second membrane 50E is more reliably suppressed, it is possible to more reliably secure compensation accuracy by the reference element 40.

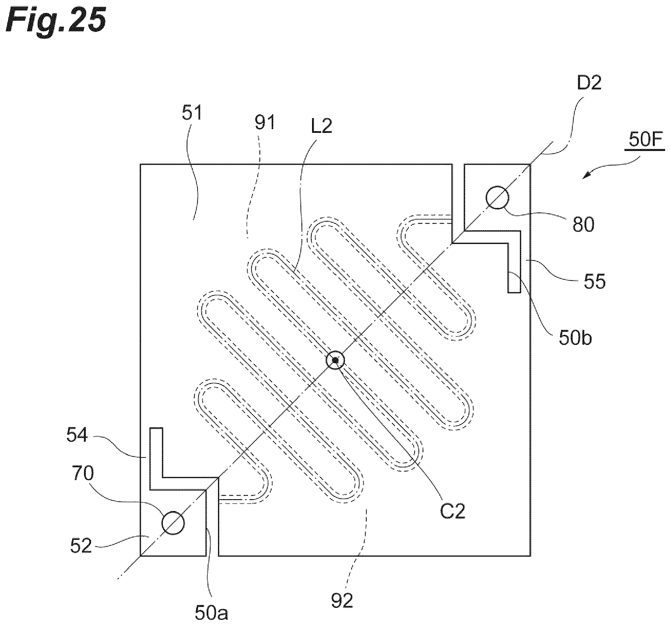

Further, as illustrated in FIG. 25, in the second membrane 50F, when the length of each of the pair of second beam portions 54 and 55 is shorter than the length of each of the pair of first beam portions 24 and 25, the second wiring layer 91 may spread toward the side opposite to the second wiring layer 92 with respect to the second gap G2 when viewed from the thickness direction of the substrate 2 and the second wiring layer 92 may spread toward the side opposite to the second wiring layer 91 with respect to the second gap G2 when viewed from the thickness direction of the substrate 2.

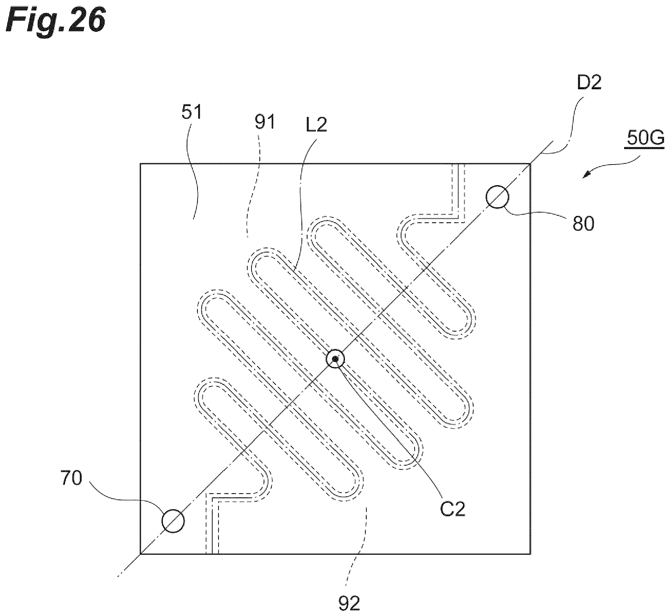

Further, as illustrated in FIG. 26, as compared with a case in which the outer shape of the second membrane 50G when viewed from the thickness direction of the substrate 2 is formed in a polygonal shape (here, a rectangular shape) by the main body portion 51, the second wiring layer 91 may spread toward the side opposite to the second wiring layer 92 with respect to the second gap G2 when viewed from the thickness direction of the substrate 2 and the second wiring layer 92 may spread toward the side opposite to the second wiring layer 91 with respect to the second gap G2 when viewed from the thickness direction of the substrate 2.

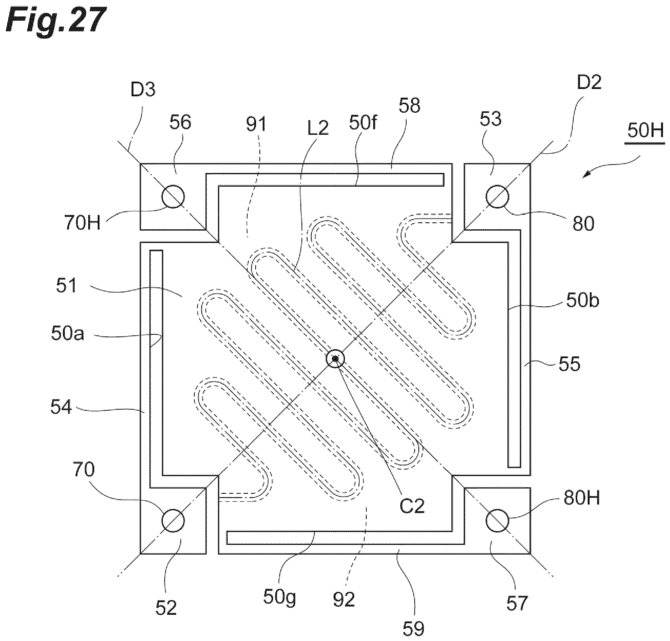

Further, as illustrated in FIG. 27, the reference element 40 may further include a pair of third electrode posts 70H and 80H. The pair of third electrode posts 70H and 80H are disposed between the substrate 2 and the second membrane 50H so as to support the second membrane 50H and to be electrically connected to each of the pair of second wiring layers 91 and 92. The pair of third electrode posts 70H and 80H are located the diagonals different from the diagonals in which the pair of second electrode posts 70 and 80 of the second membrane 50H are located when viewed from the thickness direction of the substrate 2. Specifically, the second membrane 50H further includes a pair of third connection portions 56 and 57 and a pair of third beam portions 58 and 59. The third connection portions 56 and 57 are located the diagonals different from the diagonals of the second membrane 50H in which the second connection portions 52 and 53 are located. That is, the third connection portions 56 and 57 are located at both sides of the main body portion 51 in a direction along the third diagonal line D3 different from the second diagonal line D2. Then, the third electrode post 70H is disposed between the substrate 2 and the third connection portion 56. The third electrode post 80H is disposed between the substrate 2 and the third connection portion 57. According to this configuration, since the deformation of the second membrane 50H is more reliably suppressed, it is possible to more reliably secure compensation accuracy by the reference element 40. Additionally, the third beam portion 58 is disposed between the main body portion 51 and the third connection portion 56. The third beam portion 59 is disposed between the main body portion 51 and the third connection portion 57.

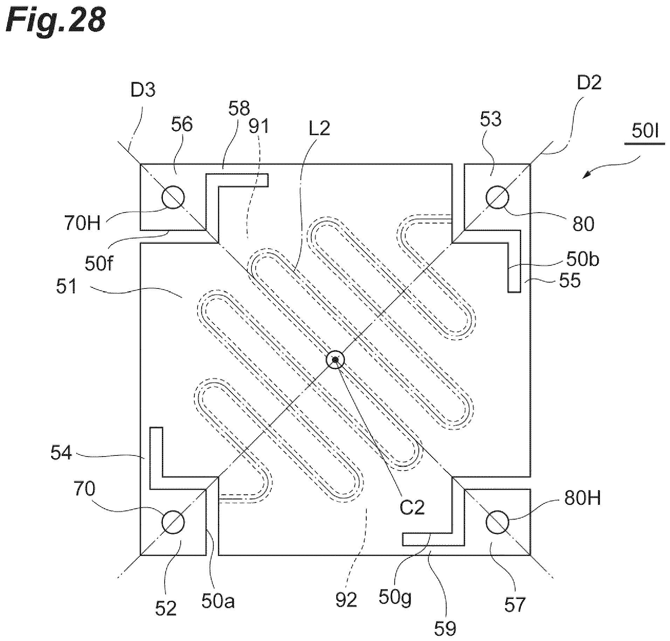

Further, as illustrated in FIG. 28, in the second membrane 50I, when the reference element 40 further includes a pair of third electrode posts 70H and 80H, the length of each of the second beam portions 54 and 55 and the third beam portions 58 and 59 may be shorter than the length of each of the first beam portions 24 and 25.

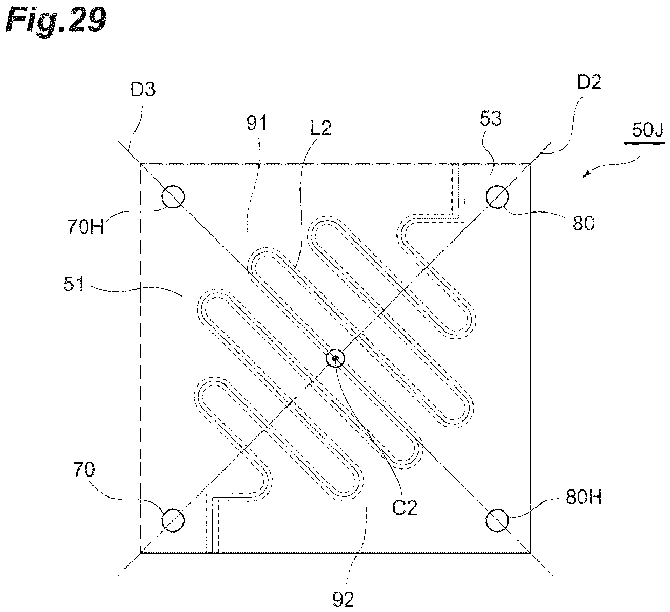

Further, as illustrated in FIG. 29, in the second membrane 50J, when the reference element 40 further includes a pair of third electrode posts 70H and 80H, the outer shape of the second membrane 50J when viewed from the thickness direction of the substrate 2 may be formed in a polygonal shape (here, a rectangular shape) by the main body portion 51.

Further, an example in which the first membrane 20 and the second membrane 50 have, for example, a rectangular shape when viewed from the thickness direction of the substrate 2 has been described, but the present disclosure is not limited thereto. Each of the first membrane 20 and the second membrane 50 may have a polygonal shape other than the rectangular shape when viewed from the thickness direction of the substrate 2. That is, the outer shape of each of the first membrane 20 and the second membrane 50 when viewed from the thickness direction of the substrate 2 may be a polygonal shape. In this case, in at least the reference element 40, the second line L2 may extend between the diagonals facing each other with the geometric center position C2 of the second membrane 50 interposed therebetween when viewed from the thickness direction of the substrate 2.

Further, the outer shape of the main body portion 51 when viewed from the thickness direction of the second substrate 202 is a polygonal shape (here, an octagonal shape, see FIGS. 7 and 8) and the second line L2 may extend between the diagonals facing each other with the geometric center position of the main body portion 51 interposed therebetween when viewed from the thickness direction of the second substrate 202. In this case, in the reference element 40, the pair of second wiring layers 91 and 92 face each other through the second gap G2 extending between the diagonals facing each other with the geometric center position of the main body portion 51 interposed therebetween. Accordingly, the pair of second wiring layers 91 and 92 can support the main body portion 51 in a more balanced manner as compared with a case in which the second gap G2 extends at a position other than between the diagonals. Accordingly, the deformation (curvature, bending, or the like) of the main body portion 51 is suppressed. Thus, compensation accuracy by the reference element 40 can be secured. As described above, such an effect is particularly noticeable when one reference element 40 is used for the compensation of the plurality of light detecting elements 10.

Additionally, as described above, if the outer shape of the main body portion 51 when viewed from the thickness direction of the second substrate 202 is a polygonal shape, the corner portion of the main body portion 51 may include a corner portion formed to be recessed toward the geometric center position of the main body portion 51. That is, the second line L2 may extend between the diagonals including a corner portion formed to be recessed toward the geometric center position of the main body portion 51 and interposing the geometric center position of the main body portion 51. Further, the second beam portions 54 and 55 may not extend along the outer edge of the main body portion 51.

Further, the through-holes 20c, 20d, 50c, and 50d when viewed from the thickness direction of the substrate 2 may have various shapes such as an oval shape or a square shape. Further, the formation positions of the through-holes 20c, 20d, 50c, and 50d are not limited. The through-holes 20c, 20d, 50c, and 50d may be formed at various positions of each of the light receiving portion 21 and the main body portion 51.

Further, the pixel unit 3 may be configured as one light detecting element 10 and the reference unit 4 may be configured as one reference element 40.

### Reference Signs List

1: light detector, 7, 8: first electrode post, 10: light detecting element, 20: first membrane, 21: light receiving portion, 22, 23: first connection portion, 24, 25: first beam portion, 31, 32: first wiring layer, 35: first resistance layer, 40: reference element, 50: second membrane, 51: main body portion, 52, 53: second connection portion, 54, 55: second beam portion, 70, 80: second electrode post, 70H, 80H: third electrode post, 91, 92: second wiring layer, 95: second resistance layer, 96: light reflection layer, 201: first substrate, 201a: first surface, 202: second substrate, 202a: second surface, C1: geometric center position, C2: geometric center position, G1: first gap, G2: second gap, L1: first line, L2: second line, S1: void space, S2: void space.

## Claims

1. A light detector comprising:
a light detecting element which detects light on the basis of a change in temperature due to receiving of light; and
a reference element which compensates a change in temperature due to a factor other than the receiving of light in the light detecting element,
wherein the light detecting element includes a first substrate and a first membrane which is disposed on a first surface of the first substrate so as to form a void space between the first membrane and the first surface,
wherein the first membrane includes a pair of first wiring layers which faces each other with a first gap extending along a first line interposed therebetween and a first resistance layer which is electrically connected to each of the pair of first wiring layers and has an electrical resistance depending on a temperature,
wherein the reference element includes a second substrate and a second membrane which is disposed on a second surface of the second substrate so as to form a void space between the second membrane and the second surface,
wherein the second membrane includes a pair of second wiring layers which faces each other with a second gap extending along a second line interposed therebetween and a second resistance layer which is electrically connected to each of the pair of second wiring layers and has an electrical resistance depending on a temperature,
wherein an outer shape of the second membrane when viewed from a direction perpendicular to the second surface is a polygonal shape, and
wherein the second line extends between diagonals facing each other with a geometric center position of the second membrane interposed therebetween when viewed from a direction perpendicular to the second surface.

2. The light detector according to claim 1,
wherein the second line extends in a meandering manner when viewed from a direction perpendicular to the second surface.

3. The light detector according to claim 1 or 2,
wherein the first membrane includes a light receiving portion which has an electrical connection area between the first resistance layer and each of the pair of first wiring layers, a pair of first connection portions, and a pair of first beam portions each of which is disposed between the light receiving portion and each of the pair of first connection portions,
wherein the light detecting element further includes a pair of first electrode posts each of which is disposed between the first substrate and each of the pair of first connection portions so as to support the first membrane and to be electrically connected to each of the pair of first wiring layers,
wherein the second membrane includes a main body portion which has an electrical connection area between the second resistance layer and each of the pair of second wiring layers, a pair of second connection portions, and a pair of second beam portions each of which is disposed between the main body portion and each of the pair of second connection portions,
wherein the outer shape of the second membrane when viewed from a direction perpendicular to the second surface is formed in the polygonal shape by the main body portion, the pair of second connection portions, and the pair of second beam portions,
wherein the reference element further includes a pair of second electrode posts each of which is disposed between the second substrate and each of the pair of second connection portions so as to support the second membrane and to be electrically connected to each of the pair of second wiring layers, and
wherein a length of each of the pair of second beam portions is shorter than a length of each of the pair of first beam portions.

4. The light detector according to claim 1 or 2,
wherein the first membrane includes a light receiving portion which has an electrical connection area between the first resistance layer and each of the pair of first wiring layers, a pair of first connection portions, and a pair of first beam portions each of which is disposed between the light receiving portion and each of the pair of first connection portions,
wherein the light detecting element further includes a pair of first electrode posts each of which is disposed between the first substrate and each of the pair of first connection portions so as to support the first membrane and to be electrically connected to each of the pair of first wiring layers,
wherein the second membrane includes a main body portion which has an electrical connection area between the second resistance layer and each of the pair of second wiring layers,
wherein the outer shape of the second membrane when viewed from a direction perpendicular to the second surface is formed in the polygonal shape by the main body portion, and
wherein the reference element further includes a pair of second electrode posts each of which is disposed between the second substrate and each of a pair of corner portions of the main body portion so as to support the second membrane and to be electrically connected to each of the pair of second wiring layers.

5. The light detector according to any one of claims 1 to 4,
wherein the reference element further includes a light reflection layer which is formed on a surface at the side opposite to the second substrate in the second membrane.

6. The light detector according to any one of claims 1 to 5,
wherein one of the pair of second wiring layer spreads toward the side opposite to the other of the pair of second wiring layers with respect to the second gap when viewed from a direction perpendicular to the second surface, and
wherein the other of the pair of second wiring layers spreads toward the side opposite to the one of the pair of second wiring layers with respect to the second gap when viewed from a direction perpendicular to the second surface.

7. The light detector according to any one of claims 1 to 6,
wherein the reference element further includes a pair of third electrode posts which is disposed between the second substrate and the second membrane so as to support the second membrane and to be electrically connected to each of the pair of second wiring layers,
wherein the pair of second electrode posts are located at the diagonals of the second membrane when viewed from a direction perpendicular to the second surface, and
wherein the pair of third electrode posts are located at diagonals different from the diagonals of the second membrane when viewed from a direction perpendicular to the second surface.

8. The light detector according to any one of claims 1 to 7,
wherein an outer shape of the first membrane when viewed from a direction perpendicular to the first surface is a polygonal shape, and
wherein the first line extends between diagonals facing each other with a geometric center position of the first membrane interposed therebetween when viewed from a direction perpendicular to the first surface.

9. A light detector comprising:
a light detecting element which detects light on the basis of a change in temperature due to receiving of light; and
a reference element which compensates a change in temperature due to a factor other than the receiving of light in the light detecting element,
wherein the light detecting element includes a first substrate and a first membrane which is disposed on a first surface of the first substrate so as to form a void space between the first membrane and the first surface,
wherein the first membrane includes a pair of first wiring layers which faces each other with a first gap extending along a first line interposed therebetween and a first resistance layer which is electrically connected to each of the pair of first wiring layers and has an electrical resistance depending on a temperature,
wherein the first membrane includes a light receiving portion which has an electrical connection area between the first resistance layer and each of the pair of first wiring layers,
wherein the reference element includes a second substrate and a second membrane which is disposed on a second surface of the second substrate so as to form a void space between the second membrane and the second surface,
wherein the second membrane includes a pair of second wiring layers which faces each other with a second gap extending along a second line interposed therebetween and a second resistance layer which is electrically connected to each of the pair of second wiring layers and has an electrical resistance depending on a temperature,
wherein the second membrane includes a main body portion which has an electrical connection area between the second resistance layer and each of the pair of second wiring layers,
wherein an outer shape of the main body portion when viewed from a direction perpendicular to the second surface is a polygonal shape, and
wherein the second line extends between diagonals facing each other with a geometric center position of the main body portion interposed therebetween when viewed from a direction perpendicular to the second surface.
